# EUROPEAN PATENT APPLICATION

(11) **EP 4 701 352 A1**
(43) Date of publication of application: **25.02.2026**
(21) Application number: 25727344.1
(22) Date of filing: 25.04.2025
(51) Int. Cl.: H05K 1/11, H05K 1/14, H04M 1/02

(54) **ELECTRONIC DEVICE INCLUDING PRINTED CIRCUIT BOARD**

(30) Priority: 12.07.2024 KR 20240092396; 20.08.2024 KR 20240111120
(71) Applicant: Samsung Electronics Co., Ltd, Suwon-si, Gyeonggi-do 16677 (KR)
(72) Inventor: KIM, Bongsoo, Suwon-si, Gyeonggi-do 16677 (KR); KANG, Jooyoung, Suwon-si, Gyeonggi-do 16677 (KR); KANG, Hyunggwang, Suwon-si, Gyeonggi-do 16677 (KR); KIM, Moonsun, Suwon-si, Gyeonggi-do 16677 (KR); KIM, Youngho, Suwon-si, Gyeonggi-do 16677 (KR); PARK, Sejin, Suwon-si, Gyeonggi-do 16677 (KR); BYUN, Wanju, Suwon-si, Gyeonggi-do 16677 (KR); YUN, Inkuk, Suwon-si, Gyeonggi-do 16677 (KR); LEE, Jungwoo, Suwon-si, Gyeonggi-do 16677 (KR)
(74) Representative: HGF
(86) International application number: PCT/KR2025/005639
(87) International publication number: WO 2026/014670

(57) **Abstract**

An interposer for connecting printed circuit boards (PCBs) includes an interposer substrate including a first surface and a second surface that is opposite to the first surface and at least one via structure disposed on the interposer substrate. The at least one via structure may include a first pad disposed on the first surface, a second pad spaced apart from the first pad and disposed in the interposer substrate, wherein the second pad includes a first body and at least one first opening passing through the first body, a third pad spaced apart from the second pad, at least one first via disposed between the first pad and the second pad and connected to the first body of the second pad, and a second via disposed between the second pad and the third pad.

## Description

### BACKGROUND

### 1. Field

The disclosure relates to an electronic device including a printed circuit board (PCB).

### 2. Description of Related Art

Technologies are being developed to improve the efficiency of mounting space and/or wiring space within an electronic device by efficiently arranging a plurality of electrical and/or electronic components within the electronic device.

However, the foregoing should not be construed as having been acknowledged by the applicant as a prior art to the description set forth in the disclosure, but should be construed only as a related art to the invention described herein.

### SUMMARY

### Technical Problem

In examples, electronic devices may comprise a printed circuit board assembly (PCA) comprising two or more printed circuit boards (e.g. in a stack). An interposer, comprising one or more vias (via structures), may connect the PCBs within the assembly. However, in view of differences in thermal expansion coefficients within materials used in connecting the assembly, a risk of cracks may arise in the structure.

### Summary of the Invention

According to an embodiment, an interposer for connecting printed circuit boards (PCBs) includes an interposer substrate including a first surface and a second surface that is opposite to the first surface and at least one via structure disposed on the interposer substrate. The at least one via structure may include a first pad disposed on the first surface, a second pad spaced apart from the first pad and disposed in the interposer substrate, wherein the second pad includes a first body and at least one first opening passing through the first body, a third pad spaced apart from the second pad, at least one first via disposed between the first pad and the second pad and connected to the first body of the second pad, and a second via disposed between the second pad and the third pad.

According to an embodiment, an electronic device includes a housing and a PCB disposed in an inner space of the housing. The PCB may include a first circuit board, a second circuit board, and one or more interposers disposed between the first circuit board and the second circuit board and configured to connect the first circuit board to the second circuit board in a height direction. The one or more interposers may include an interposer substrate including a first surface and a second surface that is opposite to the first surface, and at least one via structure disposed on the interposer substrate. The via structure may include a first pad disposed on the first surface and facing the first circuit board, a second pad spaced apart from the first pad and disposed in the interposer substrate, a third pad spaced part from the second pad and disposed in the interposer substrate, a fourth pad spaced apart from the third pad, disposed on the second surface, and facing the second circuit board, a first via disposed between the first pad and the second pad, a second via disposed between the second pad and the third pad, and a third via disposed between the third pad and the fourth pad. The second via may include a core portion in which a dielectric is positioned in the height direction and a boundary portion positioned to enclose the core portion in the height direction. When the first surface is viewed, a first connecting region in which the first via is connected to the second pad may overlap the boundary portion, and a second connecting region in which the third via is connected to the third pad may overlap the boundary portion.

In an embodiment, a PCB includes a plurality of via structures including a first via structure and a second via structure for electrically connecting a surface and an opposite surface of the PCB and an interposer substrate including a first surface and a second surface that is opposite to the first surface. The first via structure may include a first pad formed on the first surface of the interposer substrate, a fourth pad formed on the second surface that is opposite to the first surface, a second pad formed in the interposer substrate closer to the first pad than the fourth pad, a third pad formed in the interposer substrate closer to the fourth pad than the first pad, a second via connected to the second pad and the third pad, a first via connected to the first pad and the second pad, and a plurality of third vias connected to the fourth pad and the third pad. The second pad may include a first opening formed between the plurality of first vias and connected to an inside of the second via.

### BRIEF DESCRIPTION OF THE DRAWINGS

The above and other aspects, features, and advantages of certain embodiments of the present disclosure will be more apparent from the following detailed description, taken in conjunction with the accompanying drawings, in which:
FIG. 1 is a block diagram of an electronic device in a network environment, according to an embodiment;
FIG. 2A is a perspective view of an electronic device viewed from one direction, according to an embodiment;
FIG. 2B is a perspective view of the electronic device viewed from another direction, according to an embodiment;
FIG. 2C is an exploded perspective view of the electronic device according to an embodiment;
FIG. 3A is a diagram illustrating a plurality of circuit boards and an interposer connected to each other in a printed circuit board (PCB), according to an embodiment;
FIG. 3B is a diagram illustrating a state in which a plurality of interposers is disposed on a circuit board of the PCB, according to an embodiment;
FIG. 3C is a three-dimensional (3D) diagram illustrating an enlarged region A of FIG. 3A;
FIG. 4A is a cross-sectional view illustrating a pad and a via formed in an interposer, according to an embodiment;
FIG. 4B is a cross-sectional view taken along the line I-I of FIG. 4A according to an embodiment;
FIG. 4C is a cross-sectional view taken along the line II-II of FIG. 4A according to an embodiment;
FIG. 5A is a cross-sectional view taken along the line I-I of FIG. 4A according to an embodiment;
FIG. 5B is a cross-sectional view taken along the line II-II of FIG. 4A according to an embodiment;
FIG. 6A is a diagram illustrating an embodiment in which the interposer according to FIG. 5B further includes an extension opening;
FIG. 6B is a diagram illustrating an embodiment in which the interposer according to FIG. 5B further includes an extension opening;
FIG. 6C is a diagram illustrating an embodiment in which the interposer according to FIG. 5B further includes an extension opening;
FIG. 7A is a cross-sectional view of an embodiment in which a via of an interposer is formed in an arc shape, as viewed from above, according to an embodiment;
FIG. 7B is a cross-sectional view of the via of the interposer according to FIG. 7A, as viewed from below, according to an embodiment;
FIG. 8 is a cross-sectional view of an interposer including a plurality of stacked vias, according to an embodiment; and
FIG. 9 is a diagram illustrating an opening formed in a first pad and a fourth pad according to an embodiment and a plurality of bonding members disposed to enclose the opening.

### DETAILED DESCRIPTION

Hereinafter, embodiments will be described in detail with reference to the accompanying drawings. When describing the embodiments with reference to the accompanying drawings, like reference numerals refer to like components, and any repeated description related thereto will be omitted.

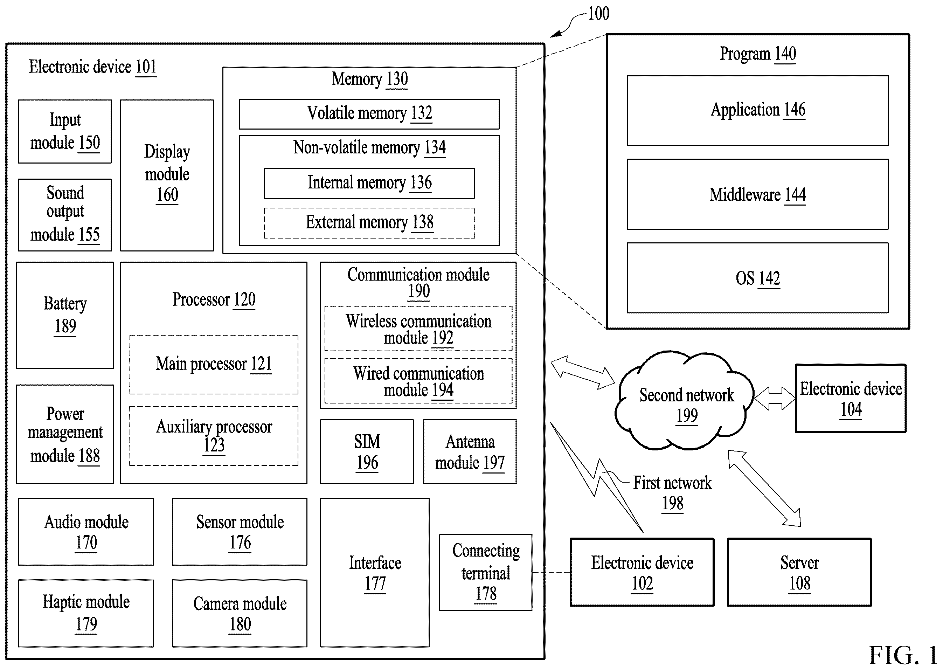

FIG. 1 is a block diagram of an electronic device in a network environment, according to various embodiments.

Referring to FIG. 1, the electronic device 101 in the network environment 100 may communicate with an electronic device 102 via a first network 198 (e.g., a short-range wireless communication network) or communicate with at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, a memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In some embodiments, at least one (e.g., the connecting terminal 178) of the components may be omitted from the electronic device 101, or one or more other components may be added to the electronic device 101. In some embodiments, some (e.g., the sensor module 176, the camera module 180, or the antenna module 197) of the components may be integrated as a single component (e.g., the display module 160).

The processor 120 may execute, for example, software (e.g., the program 140) to control at least one other component (e.g., a hardware or software component) of the electronic device 101 connected to the processor 120 and may perform various data processing or computation. According to an embodiment, as at least a portion of data processing or computation, the processor 120 may store a command or data received from another component (e.g., the sensor module 176 or the communication module 190) in a volatile memory 132, process the command or the data stored in the volatile memory 132, and store resulting data in a non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with the main processor 121. For example, when the electronic device 101 includes the main processor 121 and the assistance processor 123, the auxiliary processor 123 may be adapted to consume less power than the main processor 121 or to be specialized for a designated function. The auxiliary processor 123 may be implemented separately from the main processor 121 or as a portion of the main processor 121.

The auxiliary processor 123 may control at least some of functions or states related to at least one (e.g., the display module 160, the sensor module 176, or the communication module 190) of the components of the electronic device 101, instead of the main processor 121 while the main processor 121 is in an inactive (e.g., sleep) state or along with the main processor 121 while the main processor 121 is an active state (e.g., executing an application). According to an embodiment, the auxiliary processor 123 (e.g., an ISP or a CP) may be implemented as a portion of another component (e.g., the camera module 180 or the communication module 190) that is functionally related to the auxiliary processor 123. According to an embodiment, the auxiliary processor 123 (e.g., an NPU) may include a hardware structure specified for artificial intelligence (AI) model processing. An AI model may be generated through machine learning. Such learning may be performed by, for example, the electronic device 101, in which an AI model is executed, or performed via a separate server (e.g., the server 108). Learning algorithms may include, but are not limited to, for example, supervised learning, unsupervised learning, semi-supervised learning, or reinforcement learning. The AI model may include a plurality of artificial neural network layers. An artificial neural network may include, for example, a deep neural network (DNN), a convolutional neural network (CNN), a recurrent neural network (RNN), a restricted Boltzmann machine (RBM), a deep belief network (DBN), a bidirectional recurrent deep neural network (BRDNN), a deep Q-network, or a combination of two or more thereof, but is not limited thereto. The AI model may additionally or alternatively include a software structure other than the hardware structure.

The memory 130 may store various pieces of data used by at least one component (e.g., the processor 120 or the sensor module 176) of the electronic device 101. The data may include, for example, software (e.g., the program 140) and input data or output data for a command related thereto. The memory 130 may include the volatile memory 132 or the non-volatile memory 134.

The program 140 may be stored as software in the memory 130 and may include, for example, an operating system (OS) 142, middleware 144, or an application 146.

The input module 150 may receive, from the outside (e.g., a user) of the electronic device 101, a command or data to be used by another component (e.g., the processor 120) of the electronic device 101. The input module 150 may include, for example, a microphone, a mouse, a keyboard, a key (e.g., a button), or a digital pen (e.g., a stylus pen).

The sound output module 155 may output a sound signal to the outside of the electronic device 101. The sound output module 155 may include, for example, a speaker or a receiver. The speaker may be used for general purposes, such as playing multimedia or playing a recording. The receiver may be used to receive an incoming call. According to an embodiment, the receiver may be implemented separately from the speaker or as a part of the speaker.

The display module 160 may visually provide information to the outside (e.g., a user) of the electronic device 101. The display module 160 may include, for example, a display, a hologram device, or a projector and a control circuit to control a corresponding one of the display, the hologram device, and the projector. According to an embodiment, the display module 160 may include a touch sensor adapted to detect a touch or a pressure sensor adapted to measure an intensity of a force incurred by the touch.

The audio module 170 may convert a sound into an electric signal or vice versa. According to an embodiment, the audio module 170 may obtain the sound via the input module 150 or output the sound via the sound output module 155 or an external electronic device (e.g., an electronic device 102, such as a speaker or headphones) directly or wirelessly connected to the electronic device 101.

The sensor module 176 may detect an operational state (e.g., power or temperature) of the electronic device 101 or an environmental state (e.g., a state of a user) external to the electronic device 101 and generate an electric signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., by wire) or wirelessly. According to an embodiment, the interface 177 may include, for example, a high-definition multimedia interface (HDMI), a universal serial bus (USB) interface, a secure digital (SD) card interface, or an audio interface.

The connecting terminal 178 may include a connector via which the electronic device 101 may be physically connected to an external electronic device (e.g., the electronic device 102). According to an embodiment, the connecting terminal 178 may include, for example, an HDMI connector, a USB connector, an SD card connector, or an audio connector (e.g., a headphone connector).

The haptic module 179 may convert an electric signal into a mechanical stimulus (e.g., a vibration or a movement) or an electrical stimulus, which may be recognized by a user via his or her tactile sensation or kinesthetic sensation. According to an embodiment, the haptic module 179 may include, for example, a motor, a piezoelectric element, or an electric stimulator.

The camera module 180 may capture a still image and moving images. According to an embodiment, the camera module 180 may include one or more lenses, image sensors, ISPs, or flashes.

The power management module 188 may manage power supplied to the electronic device 101. According to an embodiment, the power management module 188 may be implemented as, for example, at least a part of a power management integrated circuit (PMIC).

The battery 189 may supply power to at least one component of the electronic device 101. According to an embodiment, the battery 189 may include, for example, a primary cell, which is not rechargeable, a secondary cell, which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more CPs that are operable independently from the processor 120 (e.g., an AP) and that support direct (e.g., wired) communication or wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module, or a power line communication (PLC) module). A corresponding one of these communication modules may communicate with the external electronic device 104 via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., a LAN or a wide area network (WAN))). These various types of communication modules may be implemented as a single component (e.g., a single chip), or may be implemented as multiple components (e.g., multiple chips) separate from each other. The wireless communication module 192 may identify and authenticate the electronic device 101 in a communication network, such as the first network 198 or the second network 199, using subscriber information (e.g., international mobile subscriber identity (IMSI)) stored in the SIM 196.

The wireless communication module 192 may support a 5G network after a fourthgeneration (4G) network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., an mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20 gigabits per second (Gbps) or more) for implementing eMBB, loss coverage (e.g., 164 decibels (dB) or less) for implementing mMTC, or U-plane latency (e.g., 0.5 milliseconds (ms) or less for each of downlink (DL) and uplink (UL), or a round trip of 1 ms or less) for implementing URLLC.

The antenna module 197 may transmit or receive a signal or power to or from the outside (e.g., an external electronic device) of the electronic device 101. According to an embodiment, the antenna module 197 may include an antenna including a radiating element including a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in a communication network, such as the first network 198 or the second network 199, may be selected by, for example, the communication module 190 from the plurality of antennas. The signal or the power may be transmitted or received between the communication module 190 and the external electronic device via the selected at least one antenna. According to an embodiment, another component (e.g., a radio frequency integrated circuit (RFIC)) other than the radiating element may be additionally formed as a part of the antenna module 197.

According to various embodiments, the antenna module 197 may form a mmWave antenna module. According to an embodiment, the mmWave antenna module may include a PCB, a RFIC disposed on a first surface (e.g., the bottom surface) of the PCB or adjacent to the first surface and capable of supporting a designated high-frequency band (e.g., the mmWave band), and a plurality of antennas (e.g., array antennas) disposed on a second surface (e.g., the top or a side surface) of the PCB, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the external electronic devices 102 and 104 may be a device of a same type as, or a different type from, the electronic device 101. According to an embodiment, all or some of operations to be executed by the electronic device 101 may be executed at one or more external electronic devices (e.g., the external devices 102 and 104, and the server 108). For example, when the electronic device 101 needs to perform a function or a service automatically, or in response to a request from a user or another device, the electronic device 101, instead of, or in addition to, executing the function or the service, may request one or more external electronic devices to perform at least part of the function or the service. The one or more external electronic devices receiving the request may perform the at least part of the function or the service requested, or an additional function or an additional service related to the request, and may transfer a result of the performance to the electronic device 101. The electronic device 101 may provide the result, with or without further processing the result, as at least part of a response to the request. To that end, cloud computing, distributed computing, mobile edge computing (MEC), or client-server computing technology may be used, for example. The electronic device 101 may provide ultra low-latency services using, e.g., distributed computing or MEC. In another embodiment, the external electronic device 104 may include an Internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

The electronic device according to various embodiments may be one of various types of electronic devices. The electronic device may include, for example, a portable communication device (e.g., a smartphone), a computer device, a portable multimedia device, a portable medical device, a camera, a wearable device, or a home appliance device. According to an embodiment of the disclosure, the electronic devices are not limited to those described above.

It should be appreciated that embodiments of the disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related components. It is to be understood that a singular form of a noun corresponding to an item may include one or more of the things, unless the relevant context clearly indicates otherwise. As used herein, "A or B", "at least one of A and B", "at least one of A or B", "A, B or C", "at least one of A, B and C", and "at least one of A, B, or C", each of which may include any one of the items listed together in the corresponding one of the phrases, or all possible combinations thereof. Terms such as "first", "second", or "first" or "second" may simply be used to distinguish the component from other components in question, and do not limit the components in other aspects (e.g., importance or order). It is to be understood that if a component (e.g., a first component) is referred to, with or without the term "operatively" or "communicatively", as "coupled with," "coupled to," "connected with," or "connected to" another component (e.g., a second component), it means that the component may be coupled with the other component directly (e.g., by wire), wirelessly, or via a third component.

As used in connection with various embodiments of the disclosure, the term "module" may include a unit implemented in hardware, software, or firmware, and may interchangeably be used with other terms, for example, "logic", "logic block", "part", or "circuitry". A module may be a single integral component, or a minimum unit or part thereof, adapted to perform one or more functions. For example, according to an embodiment, the module may be implemented in a form of an application-specific integrated circuit (ASIC). Herein, each "module" may include circuitry.

Embodiments as set forth herein may be implemented as software (e.g., the program 140) including one or more of instructions that are stored in a storage medium (e.g., an internal memory 136 or an external memory 138) that is readable by a machine (e.g., the electronic device 101). For example, a processor (e.g., the processor 120) of the machine (e.g., the electronic device 101) may invoke at least one of the one or more instructions stored in the storage medium and execute it. This allows the machine to be operated to perform at least one function according to the at least one instruction invoked. The one or more instructions may include code generated by a compiler or code executable by an interpreter. The machine-readable storage medium may be provided in the form of a non-transitory storage medium. Here, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

Herein, each "processor" may include a processing circuit or may include a plurality of processors. For example, as used in the present application including the claims, the term "processor" may include various processing circuits including at least one processor, and one or more of the at least one processor may be individually and/or collectively configured to perform the various functions described herein in a distributed manner. When "a processor," "at least one processor," and "one or more processors" are described herein as being configured to perform multiple functions, these terms include, but are not limited to, a situation in which one processor performs some of the recited functions and another processor performs another function of the recited functions and a situation in which a single processor may perform all of the recited functions. Additionally, at least one processor may include a combination of processors that perform the various cited/disclosed functions, for example, in a distributed manner. At least one processor may execute program instructions to accomplish or perform various functions.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read-only memory (CD-ROM)), or be distributed (e.g., downloaded or uploaded) online via an application store (e.g., PlayStore^{™}), or between two user devices (e.g., smartphones) directly. If distributed online, at least part of the computer program product may be temporarily generated or at least temporarily stored in the machine-readable storage medium, such as a memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

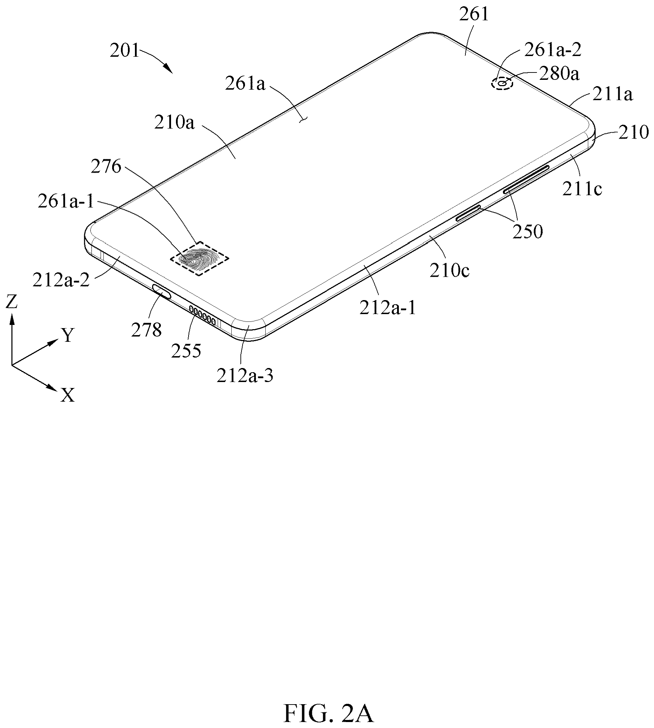

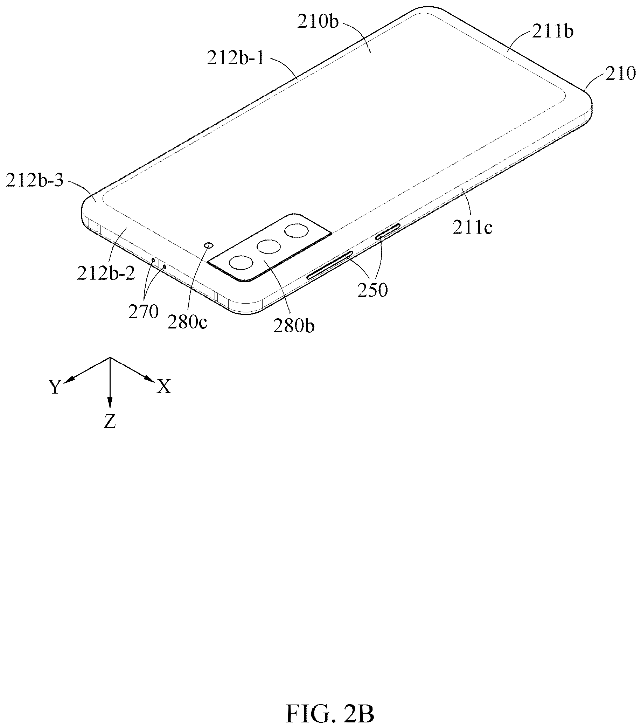

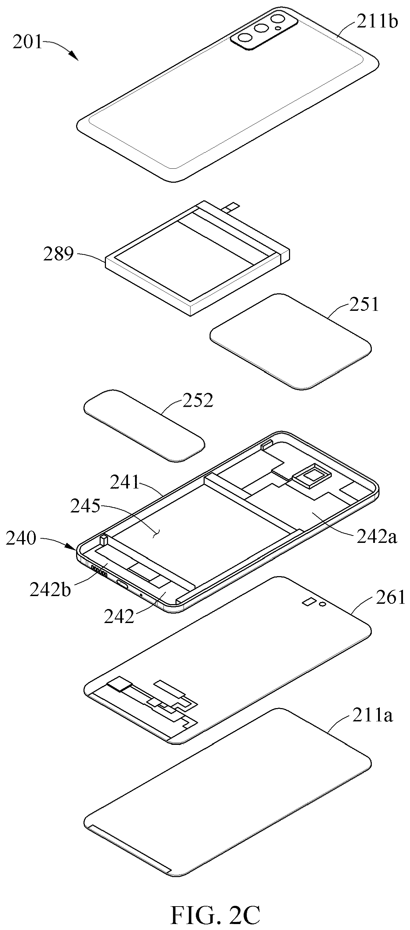

FIG. 2A is a perspective view of an electronic device viewed from one direction, according to an embodiment, FIG. 2B is a perspective view of the electronic device viewed from another direction, according to an embodiment, and FIG. 2C is an exploded perspective view of the electronic device according to an embodiment.

Referring to FIGS. 2A to 2C, an electronic device 201 (e.g., the electronic device 101 of FIG. 1) according to an embodiment may include a housing 210 having a first surface 210a (e.g., a front surface), a second surface 210b (e.g., a rear surface), and a third surface 210c (e.g., a side surface) enclosing a space between the first surface 210a and the second surface 210b.

In an embodiment, the first surface 210a may be formed by a first plate 211a of which at least a portion is substantially transparent. For example, the first plate 211a may include a polymer plate or a glass plate including at least one coating layer. In an embodiment, the second surface 210b may be formed by a second plate 211b that is substantially opaque. For example, the second plate 211b may be formed of coated or tinted glass, ceramic, polymer, metal (e.g., aluminum, stainless steel (STS), or magnesium), or a combination thereof. In an embodiment, the third surface 210c may be formed by a frame 211c that is coupled to the first plate 211a and the second plate 211b and includes a metal and/or a polymer. In an embodiment, the second plate 211b and the frame 211c may be integrally and seamlessly formed. In an embodiment, the second plate 211b and the frame 211c may be formed of substantially the same material (e.g., aluminum).

In an embodiment, the first plate 211a may include a plurality of first edge regions 212a-1. The plurality of first edge regions 212a-1 may face the second plate 211b from at least a partial region of the first surface 210a. The plurality of first edge regions 212a-1 may be in contact with the frame 211c. The plurality of first edge regions 212a-1 may extend in one direction (e.g., +/-Y direction). The first plate 211a may include a plurality of second edge regions 212a-2. The plurality of second edge regions 212a-2 may face the second plate 211b from at least a partial region of the first surface 210a. The plurality of second edge regions 212a-2 may be in contact with the frame 211c. The plurality of second edge regions 212a-2 may extend in a direction (e.g., +/-X direction) different from an extending direction (e.g., +/-Y direction) of the plurality of first edge regions 212a-1. The first plate 211a may include a plurality of third edge regions 212a-3. The plurality of third edge regions 212a-3 may face the second plate 211b from at least a partial region of the first surface 210a. The plurality of third edge regions 212a-3 may be in contact with the frame 211c. The plurality of third edge regions 212a-3 may be disposed between the plurality of first edge regions 212a-1 and the plurality of second edge regions 212a-2.

In an embodiment, the second plate 211b may include a plurality of fourth edge regions 212b-1. The plurality of fourth edge regions 212b-1 may face the first plate 211a from at least a partial region of the second surface 210b. The plurality of fourth edge regions 212b-1 may be in contact with the frame 211c. The plurality of fourth edge regions 212b-1 may extend in one direction (e.g., +/-Y direction). The second plate 211b may include a plurality of fifth edge regions 212b-2. The plurality of fifth edge regions 212b-2 may face the first plate 211a from at least a partial region of the second surface 210b. The plurality of fifth edge regions 212b-2 may be in contact with the frame 211c. The plurality of fifth edge regions 212b-2 may extend in a direction (e.g., +/-X direction) different from the extending direction (e.g., +/-Y direction) of the plurality of fourth edge regions 212b-1. The second plate 211b may include a plurality of sixth edge regions 212b-3. The plurality of sixth edge regions 212b-3 may face the first plate 211a from at least a partial region of the second surface 210b. The plurality of sixth edge regions 212b-3 may be in contact with the frame 211c. The plurality of sixth edge regions 212b-3 may be disposed between the plurality of fourth edge regions 212b-1 and the plurality of fifth edge regions 212b-2.

In an embodiment, the electronic device 201 may include a display 261 (e.g., the display module 160 of FIG. 1). In an embodiment, the display 261 may be positioned on the first surface 210a. In an embodiment, the display 261 may be visible through at least a portion of the first plate 211a (e.g., the plurality of first edge regions 212a-1, the plurality of second edge regions 212a-2, and/or the plurality of third edge regions 212a-3). In an embodiment, the display 261 may have a shape that is substantially the same as the shape of an outer edge of the first plate 211a. In an embodiment, the edge of the display 261 may substantially coincide with the outer edge of the first plate 211a.

In an embodiment, the display 261 may include a touch sensing circuit, a pressure sensor for measuring an intensity (pressure) of a touch, and/or a digitizer for detecting a magnetic-type stylus pen.

In an embodiment, the display 261 may include a screen display region 261a that is visually exposed to display content using pixels. In an embodiment, the screen display region 261a may include a sensing region 261a-1. The sensing region 261a-1 may overlap at least one region of the screen display region 261a. The sensing region 261a-1 may allow transmission of an input signal related to a sensor module 276 (e.g., the sensor module 176 of FIG. 1). The sensing region 261a-1 may display content, similarly to the screen display region 261a that does not overlap the sensing region 261a-1. For example, the sensing region 261a-1 may display the content while the sensor module 276 is not operating. At least a portion of a camera region 261a-2 may overlap the screen display region 261a. In an embodiment, the screen display region 261a may include the camera region 261a-2. The camera region 261a-2 may allow transmission of an optical signal related to a first camera module 280a (e.g., the camera module 180 of FIG. 1). At least a portion of the camera region 261a-2, that overlaps the screen display region 261a, may display content, similarly to the screen display region 261a that does not overlap the camera region 261a-2. For example, the camera region 261a-2 may display content while the first camera module 280a is not operating.

In an embodiment, the electronic device 201 may include an audio module 270 (e.g., the audio module 170 of FIG. 1). In an embodiment, the audio module 270 may be positioned on the third surface 210c. In an embodiment, the audio module 270 may obtain sound through at least one hole.

In an embodiment, the electronic device 201 may include the sensor module 276. In an embodiment, the sensor module 276 may be positioned on the first surface 210a. The sensor module 276 may form the sensing region 261a-1 in at least a portion of the screen display region 261a. The sensor module 276 may receive an input signal transmitted through the sensing region 261a-1 and generate an electrical signal based on the received input signal. For example, the input signal may have a designated physical quantity (e.g., heat, light, temperature, sound, pressure, or ultrasound). In another example, the input signal may include a signal related to biometric information (e.g., a fingerprint) of a user.

In an embodiment, the electronic device 201 may include the first camera module 280a (e.g., the camera module 180 of FIG. 1). In an embodiment, the first camera module 280a may be positioned on the first surface 210a. In an embodiment, at least a portion of the first camera module 280a may be positioned under the display 261. In an embodiment, the first camera module 280a may receive an optical signal transmitted through the camera region 261a-2.

In an embodiment, the electronic device 201 may include a second camera module 280b (e.g., the camera module 180 of FIG. 1). The second camera module 280b may be positioned on the second surface 210b. In an embodiment, the second camera module 280b may include a plurality of camera modules (e.g., a dual camera, a triple camera, or a quad camera).

In an embodiment, the electronic device 201 may include a flash 280c. The flash 280c may be positioned on the second surface 210b. In an embodiment, the flash 280c may include a light-emitting diode or a xenon lamp.

In an embodiment, the electronic device 201 may include a sound output module 255 (e.g., the sound output module 155 of FIG. 1). In an embodiment, the audio output module 255 may be positioned on the third surface 210c. In an embodiment, the sound output module 255 may include one or more holes.

In an embodiment, the electronic device 201 may include an input module 250 (e.g., the input module 150 of FIG. 1). In an embodiment, the input module 250 may be positioned on the third surface 210c. In an embodiment, the input module 250 may include at least one key input device.

In an embodiment, the electronic device 201 may include a connecting terminal 278 (e.g., the connecting terminal 178 of FIG. 1). In an embodiment, the connecting terminal 278 may be positioned on the third surface 210c. For example, when the electronic device 201 is viewed in one direction (e.g., the +Y direction), the connecting terminal 278 may be positioned substantially in a central portion of the third surface 210c, and the sound output module 255 may be positioned on one side (e.g., a right side) with respect to the connecting terminal 278.

In an embodiment, the electronic device 201 may include a support body 240, a first circuit board 251, a second circuit board 252, and a battery 289 (e.g., the battery 189 of FIG. 1). At least a portion of the support body 240 may form the housing 210 together with the first plate 211a and the second plate 211b.

In an embodiment, the support body 240 may include a first frame structure 241, a second frame structure 243, and a plate structure 242. The first frame structure 241 may surround the edge of the plate structure 242. The first frame structure 241 may connect the edge of the first plate 211a to the edge of the second plate 211b. The first frame structure 241 may enclose a space between the first plate 211a and the second plate 211b. At least a portion of the first frame structure 241 may form the third surface 210c of the electronic device 201. The second frame structure 243 may be positioned between the first frame structure 241 and the second plate 211b. The first frame structure 241 and the second frame structure 243 may at least partially form the frame 211c. The plate structure 242 may include a first portion 242a for accommodating the first circuit board 251 and a second portion 242b for accommodating the second circuit board 252. The display 261 may be positioned on one side (e.g., the lower surface or +Z-axis direction) of the plate structure 242. The first circuit board 251 and the second circuit board 252 may be positioned on the other surface (e.g., the upper surface or the -Z axis direction) of the plate structure 242. In an embodiment, the plate structure 242 may include an opening 245. The opening 245 may be positioned between the first portion 242a and the second portion 242b. The opening 245 may pass through both sides of the plate structure 242. The opening 245 may accommodate the battery 289.

Meanwhile, the embodiment(s) provided herein may also apply to electronic devices of various shapes/forms (e.g., a foldable electronic device, a slidable electronic device, a digital camera, a digital video camera, a tablet personal computer (PC), a laptop computer, and other electronic devices), in addition to the electronic device shown in FIGS. 2A to 2C.

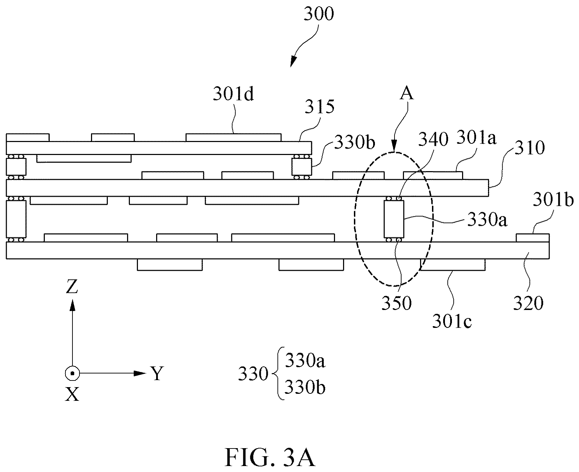

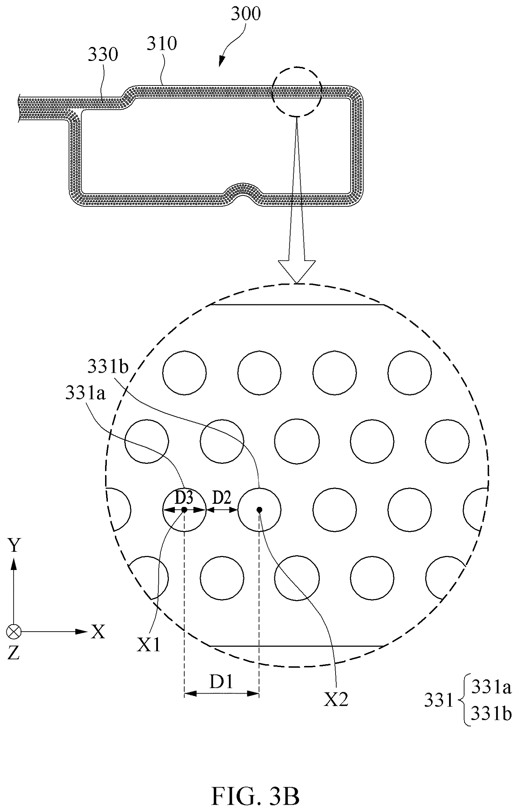

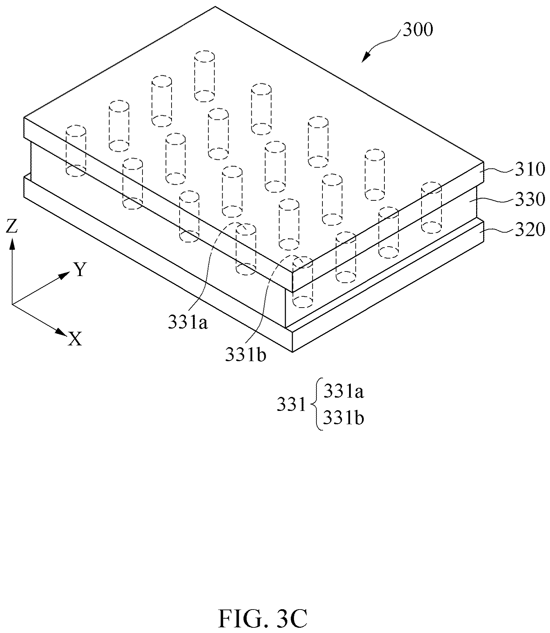

FIG. 3A is a diagram illustrating a plurality of circuit boards and an interposer connected to each other in a PCB, according to an embodiment. FIG. 3B is a diagram illustrating a state in which a plurality of interposers is disposed on a circuit board of the PCB, according to an embodiment. FIG. 3C is a three-dimensional (3D) diagram illustrating an enlarged region A of FIG. 3A.

Referring to FIGS. 3A to 3C, a PCB 300 (e.g., the PCBs 251 and 252 of FIG. 2C) according to an embodiment may be disposed in an electronic device (e.g., the electronic device 201 of any of FIGs. 2A-2C, FIG. 1). In an embodiment, the PCB 300 may be formed in a multi-layer circuit board structure including one or more circuit boards 310, 315, and 320. For example, the PCB 300 may be comprised, or disposed, within a multi-layer PCB assembly (e.g. a PCB stack comprising two or more circuit boards).

In an embodiment, the PCB 300 may include a plurality of circuit boards 310, 315, and 320 on which one or more electrical components 301a, 301b, 301c, and 301d are disposed and one or more (e.g., at least one) interposers 330 connecting the plurality of circuit boards 310, 315, and 320.

In an embodiment, the plurality of circuit boards 310, 315, and 320 may include a first circuit board 310, a second circuit board 320, and a third circuit board 315 that are arranged parallel to one another. In an embodiment, one or more electrical components 301a, 301b, 301c, and 301d may be disposed on a surface of each of the first circuit board 310, the second circuit board 320, and the third circuit board 315. For example, the electrical components may include components, such as an AP, a GPU, and a PMIC, for performing functions in the electronic device.

In an embodiment, one or more interposers 330 may be positioned (e.g., may be arranged) between the circuit boards 310, 315, and 320 disposed parallel to one another and may connect the circuit boards 310, 315, and 320 disposed parallel to one another in a height direction (e.g., the Z-axis direction of FIG. 3A). For example, the circuit boards 310, 315 and 320 may form a stack. In an embodiment, the interposer 330 may include (e.g. comprise) a via structure 331 formed through the interposer 330 in the height direction of the PCB 300. That is, the via (structure) may extend through the interposer 330. In an embodiment, the via structure 331 of the interposer 330 may electrically connect a pair of adjacent circuit boards 310 and 320 to each other. For example, the via structure 331 may be electrically connected directly or indirectly to an electrical circuit or the electrical components 301a, 301b, 301c, and 301d formed on the pair of circuit boards 310 and 320. In an embodiment, the via structure 331 may include a conductive material to electrically connect the electrical components 301a, 301b, 301c, and 301d disposed on the circuit boards 310 and 320. In an embodiment, the via structure 331 may be provided in plurality (e.g., via structures 331a and 331b) of FIG. 3B). That is, in examples, one or more (e.g., a plurality of) via structures 331 may be provided.

In an embodiment, the via structure 331 of the interposer 330 may be connected to the circuit boards 310 and 320 by one or more bonding members 340 and 350. For example, when more than one interposer connects the circuit boards (e.g., circuit boards 310, 320), a first bonding member and a second bonding member may connect each interposer to the circuit boards. For example, a first bonding member 340 may connect a first interposer 330a to the first circuit board 310. A second bonding member 350 may connect the first interposer 330a to the second circuit board 320.

In an embodiment, the first interposer 330a may electrically connect the first circuit board 310 to the second circuit board 320. A second interposer 330b may electrically connect the first circuit board 310 to the third circuit board 315. For example, the first interposer 330a may be connected to the first circuit board 310 and the second circuit board 320 through a plurality of bonding members 340 and 350. In an embodiment, the plurality of bonding members 340 and 350 may be disposed between the circuit boards 310 and 320 and the first interposer 330a and may electrically connect the circuit boards 310 and 320 to the first interposer 330a. In an embodiment, the plurality of bonding members 340 and 350 may be disposed in various shapes, and each of the plurality of bonding members 340 and 350 may be disposed in substantially the same shape.

Although the PCB 300 is illustrated as including three circuit boards 310, 315, and 320 and one or more interposers 330 connecting the three circuit boards 310, 315, and 320 in FIGS. 3A to 3C, the foregoing example is just for ease of description, and the number of the circuit boards and the number of the interposers included in the PCB 300 are not limited thereto. For example, a PCB may include four circuit boards disposed parallel to one another and one or more interposers connecting the circuit boards to one another and may include four or more circuit boards and a plurality of interposers.

Referring to FIG. 3B, the interposer 330 may be at the edge of the first circuit board 310. For example, the interposer 330 may be disposed (e.g., arranged, located) along at least a portion of the perimeter of the first circuit board 310 and may connect the first circuit board 310 to the second circuit board 320. For example, the interposer 330 may be disposed in a closed-loop form along the edges of the first circuit board 310 and the second circuit board 320. In an embodiment, when the interposer 330 may be at the edge of the first circuit board 310, the edge of the first circuit board 310 may be formed in a shape corresponding to the edge of the interposer 330.

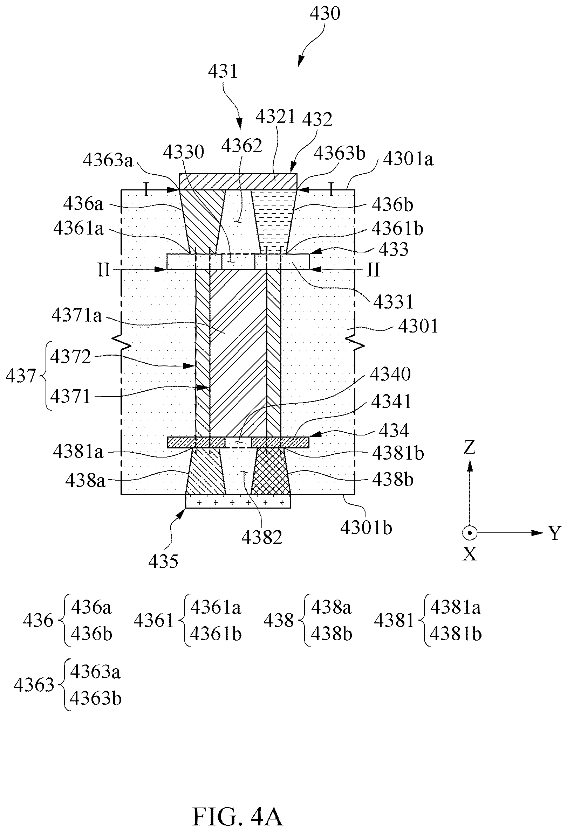

When the interposer 330 according to an embodiment is viewed in the height direction (e.g., from above, in the Z-axis direction of FIG. 3B), each of the via structures 331a and 331b may have a diameter D3 and be spaced apart from each other by a second displacement D2 (e.g., a second distance D2). In an embodiment, central axes X1 and X2 of the via structures 331a and 331b that are adjacent to each other may be spaced apart from each other by a first displacement D1. In an embodiment, the first displacement (e.g. a first distance) D1 formed by the central axes X1 and X2 of the via structures 331a and 331b that are adjacent to each other may be a displacement between the central axes of via structures (e.g., pads (e.g., a first pad 432 of FIG. 4A) of a via structure 431 of FIG. 4A).

In an embodiment, the first distance D1 may be related to circuit density and electrical characteristics of circuits. That is, a distance between the via structures, may be arranged or determined in accordance with (or in consideration of) a circuit density (e.g., a density of structural circuit components and/or arrangement). For example, when the first distance D1 is reduced (that is, when the distance D1 is smaller), more circuits may be disposed (arranged) in the same region, thereby providing that circuit density may be increased. More circuits may be disposed in a smaller space, thereby increasing integration. On the other hand, when the first distance D1 increases, the design becomes simpler and the number of circuits that may be (are able to be) disposed in the same region decreases, which may lower integration. A via structure 331 (e.g., a via structure 431 of FIG. 4A) according to an embodiment to be described below may form the first displacement D1 of a small value (that is, a small distance between the central axes of via structures) sufficient to secure the integration of a circuit by securing a large diameter D3 of a pad and, accordingly, securing a small second displacement D2 spaced apart from each other. For example, the via structure 431 may comprise a plurality of vias (e.g. via structures 331a and 33b) that are arranged to be spaced apart (e.g. at a distance) by a small value of the first displacement D1 (and/or the second displacement D2), to provide a high circuit density in the interposer region, as more connection (integration) may be provided. A large diameter D3 (that is, of a pad on a surface of the via structure/interposer) may also (additionally) be provided to aid circuit integration (connection).

In an embodiment, the distance D1 between the central axes X1 and X2 of the via structures 331a and 331b, respectively, may be about 550 micrometers (µm) or less. For example, the distance D1 between the central axes X1 and X2 may be about 540 µm or less, about 530 µm or less, about 520 µm or less, about 510 µm or less, or about 500 µm or less.

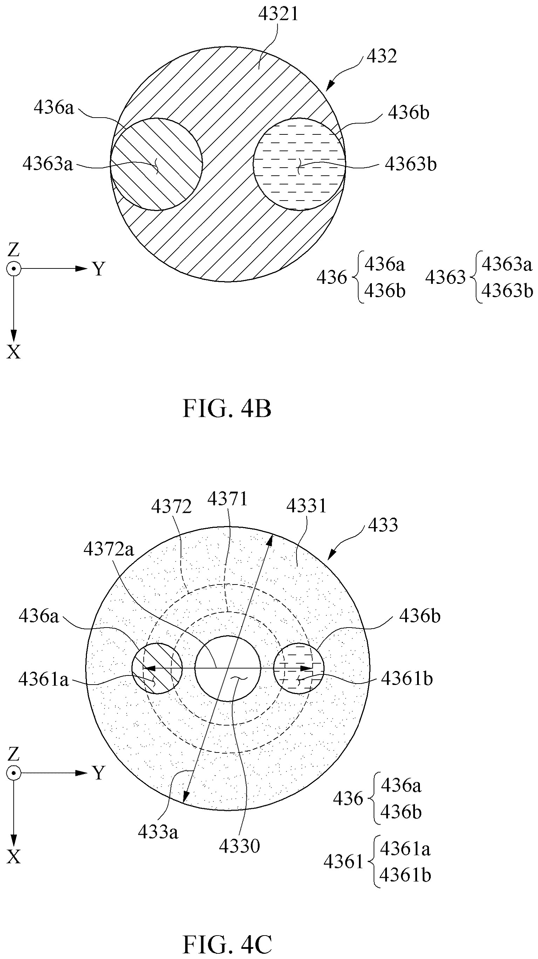

FIG. 4A is a cross-sectional view illustrating a pad and a via formed in an interposer, according to an embodiment. FIG. 4B is a cross-sectional view taken along the line I-I of FIG. 4A according to an embodiment. FIG. 4C is a cross-sectional view taken along the line II-II of FIG. 4A according to an embodiment.

Hereinafter, it may be understood that the height direction of the interposer 430 may be the Z-axis direction based on FIG. 4A. However, the height direction of the interposer 430 is not limited thereto, and this is simply for the purpose of description. Hereinafter, "overlapping" between components may represent that at least some of the components overlap (or a least partially overlap) one another based on a direction in which the components are viewed from a predetermined direction or in a predetermined state. For example, one component and another component overlapping each other may represent that the entirety of one component and the entirety of the other component overlap each other, or the entirety of one component and a portion of the other component overlap each other, or a portion of one component and the entirety of the other component overlap each other, or a portion of one component and a portion of the other component overlap each other. "Not overlapping" between components may represent that at least some of components do not overlap one another, based on a direction in which the components are viewed from a predetermined direction or in a predetermined state. For example, one component and another component not overlapping each other may represent that the entirety of one component and the entirety of the other component do not overlap each other, or the entirety of one component and a portion of the other component do not overlap each other, or a portion of one component and the entirety of the other component do not overlap each other, or a portion of one component and a portion of the other component do not overlap each other.

In an embodiment, the interposer 430 (e.g., the interposer 330 of FIG. 3A) may include an interposer substrate 4301 and at least one via structure 431 (e.g., the via structure 331a or 331b of FIG. 3B) disposed on the interposer substrate 4301.

The interposer substrate 4301 according to an embodiment may form the exterior of the interposer 430. The interposer substrate 4301 may include a first surface 4301a and a second surface 4301b. The first surface 4301a of the interposer substrate 4301 may be disposed in a direction opposite to the second surface 4301b.

In an embodiment, the via structure 431 may be disposed on the interposer substrate 4301. In an embodiment, the number of via structures 431 disposed on one interposer substrate 4301 may be one, two or more (e.g., a plurality of via structures). FIGS. 4A to 4C illustrate one via structure, but this is simply for the purpose of description, and more than one via structure may be disposed. In an embodiment, but not limited thereto, the via structure 431 may comprise the first pad 432, a second pad 433, a third pad 434, a fourth pad 435, a first via 436, a second via 437, and a third via 438.

According to an embodiment, the first pad 432, the second pad 433, the third pad 434, and the fourth pad 435 of the via structure 431 may be formed to extend in a direction (e.g., the Y-axis direction of FIG. 4A) substantially perpendicular to the height direction (e.g., the Z-axis direction of FIG. 4A) of the interposer 430. In an embodiment, an electrical signal may be transmitted and/or transferred through the first pad 432, the second pad 433, the third pad 434, the fourth pad 435, the first via 436, the second via 437, and the third via 438 of the via structure 431.

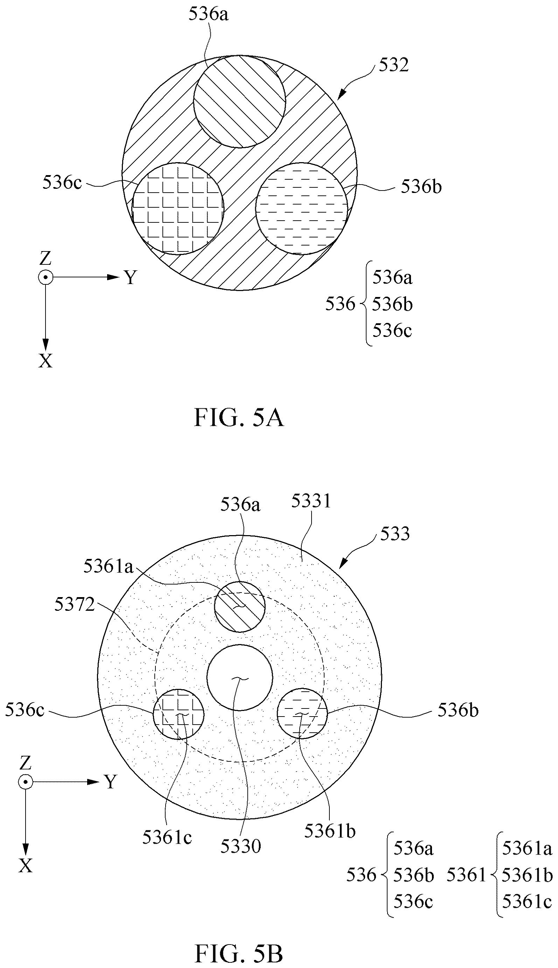

Hereinafter, unless otherwise stated, the description of the first pad 432 may apply to the fourth pad 435 substantially in the same manner, and the description of the second pad 433 may apply to the third pad 434 substantially in the same manner. The description of the first via 436 according to an embodiment may apply to the third via 438 substantially in the same manner. The same applies to the descriptions with reference to FIGS. 5A to 9.

In an embodiment, the first pad 432 may be disposed on the first surface 4301a of the interposer substrate 4301. For example, the first pad 432 may be disposed to be at least partially exposed to the outside of the interposer substrate 4301 through the first surface 4301a. In an embodiment, the first pad 432 may include a third body 4321 that forms the exterior of the first pad 432.

In an embodiment, the fourth pad 435 may be disposed on the second surface 4301b of the interposer substrate 4301. For example, the fourth pad 435 may be disposed to be at least partially exposed to the outside of the interposer substrate 4301 through the second surface 4301b. According to an embodiment, the fourth pad 435 may be omitted when the third pad 434 to be described below is disposed on the second surface 4301b of the interposer substrate 4301.

In an embodiment, the first pad 432 and the fourth pad 435 may each be connected to a circuit board (e.g., the circuit boards 310, 315, and 320 of FIG. 3A) by a bonding member (e.g., the bonding members 340 and 350 of FIG. 3A). In an embodiment, the first pad 432 and the fourth pad 435 may be positioned at the edge of the perimeter of the circuit board. In an embodiment, the first pad 432 and the fourth pad 435 may each have a diameter (e.g., the diameter D3 of FIG. 3B).

In an embodiment, the second pad 433 may be spaced apart from the first pad 432 in the height direction (e.g., the -Z-axis direction of FIG. 4A) of the interposer 430. In an embodiment, the second pad 433 may be disposed in the interposer substrate 4301. In an embodiment, the second pad 433 may include a first body 4331 forming an exterior. In an embodiment, a first opening 4330 may be formed in the first body 4331 of the second pad 433. In an embodiment, the first opening 4330 may be formed through (e.g. may extend through) the first body 4331.

In an embodiment, the third pad 434 may be spaced apart from the second pad 433 in the height direction (e.g., the -Z-axis direction of FIG. 4A) of the interposer 430 (e.g., in a direction of the second surface 4301b of the interposer). In an embodiment, the third pad 434 may be disposed in the interposer substrate 4301. However, this is only an example, and the third pad 434 according to an embodiment may be disposed on the second surface 4301b of the interposer substrate 4301. When the third pad 434 according to an embodiment is disposed on the second surface 4301b of the interposer substrate 4301, the second via 437 may be formed to extend from the second pad 433 to the second surface 4301b of the interposer substrate 4301. In an embodiment, the second pad 433 may include a second body 4341 forming an exterior. In an embodiment, a second opening 4340 may be formed in (e.g., extend through) the second body 4341 of the third pad 434. In an embodiment, the second opening 4340 may be formed through the second body 4341.

In an embodiment, the via structure 431 is illustrated as having the first opening 4330 and the second opening 4340 formed therein, but this is only an example, and the first opening 4330 and the second opening 4340 do not necessarily have to be formed together. For example, in the via structure 431 according to an embodiment, only the first opening 4330 may be formed and no opening may be formed in the third pad 434, or only the third opening 4340 may be formed and no opening may be formed in the first pad 433.

In an embodiment, based on the direction (e.g., the Z-axis direction in FIG. 4A) facing the first surface 4301a or the second surface 4301b of the interposer 430, the first pad 432, the second pad 433, the third pad 434, and the fourth pad 435 may at least partially overlap one another. The first pad 432, the second pad 433, the third pad 434, and the fourth pad 435 that are disposed to at least partially overlap one another may increase the structural stability of the interposer 430.

According to an embodiment, the first via 436 may be disposed between the first pad 432 disposed on the first surface 4301a of the interposer 430 and the second pad 433 spaced apart from the first pad 432 and disposed in the interposer substrate 4301. That is, the first via 436 may extend between the first pad 432 and the second pad 433. In an embodiment, a portion in which the first via 436 is connected to the second pad 433 may not overlap the first opening 4330. For example, the first via 436 may be connected to the second pad 433 in a first connecting region 4361 (e.g. at a portion or body of the second pad 433). In an embodiment, the first connecting region 4361 in which the first via 436 is connected to the second pad 433 may not overlap the first opening 4330 based on the direction facing the first surface 4301a of the interposer 430. In an embodiment, the first via 436 may be connected to the first pad 432 in a third connecting region 4363. In an embodiment, the area of the third connecting region 4363 of the first pad 432 may be greater than the area of the first connecting region 4361 of the second pad 433. In an embodiment, the first via 436 may be positioned to be in contact with at least a portion of the perimeter of the first pad 432 (e.g., the third body 4321 of the first pad 432) with respect to a cross-section (e.g., an XY plane of FIG. 4B) perpendicular to the height direction (e.g., the Z-axis direction of FIG. 4B) of the interposer 430.

In an embodiment, the number of first vias 436 may be one or more. For example, the number of first vias 436 may be one, two, three or more. In an embodiment, when a plurality of first vias 436 is provided, the plurality of first vias 436a and 436b may connect the first pad 432 to the second pad 433 so as not to overlap the first opening 4330 formed in the second pad 433. For example, the plurality of first vias 436a and 436b may be connected to the second pad 433 in a plurality of respective first connecting regions 4361a and 4361b. In an embodiment, each of the plurality of first connecting regions 4361a and 4361b may not overlap the first opening 4330. In an embodiment, the plurality of first vias 436a and 436b may be spaced apart from each other. For example, a first gap 4362 may be formed between the plurality of first vias 436a and 436b. According to an embodiment, a core portion 4371 of a second via 437 may be exposed from the first gap 4362 through the first opening 4330 formed in the second pad 433. That is, the core portion 4371 extends between the second pad 433 and the third pad 434 in a height direction of the interposer substrate 4301, and may be exposed to (visible through) the first opening 4330 from the first gap 4362. In an embodiment, the plurality of first vias 436a and 436b may be .connected to the first pad 432 in a plurality of third connecting regions 4363a and 4363b.

In an embodiment, the first via 436 may have at least one cross-sectional shape of a circle, an ellipse, and a polygon, with respect to a cross-section (e.g., an XY cross-section of FIG. 4A) perpendicular to the height direction (e.g., the Z-axis direction of FIG. 4A). In an embodiment, the second via 437 and the third via 438 described below may have the same cross-sectional shape as the first via 436 or may have different cross-sectional shapes.

According to an embodiment, the third via 438 may connect the fourth pad 435 disposed on the second surface 4301b of the interposer 430 and the third pad 434 spaced apart from the fourth pad 435 and disposed in the interposer substrate 4301. In an embodiment, the third via 438 may be positioned not to overlap the second opening 4340 formed in the third pad 434. For example, based on the direction (e.g., the +Z direction of FIG. 4A) facing the second surface 4301b of the interposer 430, the third via 438 may not overlap the second opening 4340 of the third pad 434. In an embodiment, the third via 438 may be formed symmetrically with respect to the first via 436 based on the second via 437. For example, when the first surface 4301a of the interposer 430 is viewed, the third via 438 may be formed to overlap with the first via 436. In an embodiment, based on a cross-section (e.g., the XY plane of FIG. 4B) perpendicular to the height direction (e.g., the Z-axis direction of FIG. 4B) of the interposer 430, the third via 438 may be positioned to be in contact with at least a portion of the perimeter of the fourth pad 435.

In an embodiment, the number of third vias 438 may be one or more. For example, the number of third vias 438 may be one, two, three or more. In an embodiment, when a plurality of third vias 438 is provided, the plurality of third vias 438a and 438b may connect the third pad 434 to the fourth pad 435 so as not to overlap the second opening 4340 formed in the third pad 434. For example, the plurality of third vias 438a and 438b may be connected to the third pad 434 in a plurality of second connecting regions 4381. In an embodiment, each of the plurality of second connecting regions 4381a and 4381b may not overlap the second opening 4340. In an embodiment, the plurality of third vias 438 may be spaced apart from each other. The plurality of third vias 438a and 438b may form a second gap 4382. The second gap 4382 formed by the plurality of third vias 438a and 438b may overlap the second opening 4340 formed in the third pad 434.

In an embodiment, at least one of the first via 436 or the third via 438 may be formed by laser processing. In an embodiment, at least one of the first via 436 or the third via 438 may be formed of a metal material.

In an embodiment, the second via 437 may be formed in the interposer substrate 4301. In an embodiment, the second via 437 may be disposed between the second pad 433 and the third pad 434 disposed in the interposer substrate 4301. In an embodiment, the second via 437 may be formed by drilling. In an embodiment, the second via 437 may include the core portion 4371 and a boundary portion 4372.

In an embodiment, the core portion 4371 may form the center of the second via 437. For example, the core portion 4371 may be formed in the height direction (e.g., the Z-axis direction of FIG. 4A, e.g. a height direction of the interposer substrate) at the center of the second via 437. A dielectric 4371a may be positioned and/or filled in the core portion 4371 of the second via 437. In an embodiment, when the first surface 4301a of the interposer 430 is viewed, the core portion 4371 may overlap the first opening 4330 of the second pad 433. In an embodiment, when the second surface 4301b of the interposer 430 is viewed, the core portion 4371 may overlap the second opening 4340 of the third pad 434. In an embodiment, both sides (e.g., both sides in the Z-axis direction of FIG. 4A) of the dielectric 4371a positioned in the core portion 4371 may be partially exposed to the outside (e.g. an outside of the second via 437) through the first opening 4330 of the second pad 433 and the second opening 4340 of the third pad 434.

In an embodiment, the core portion 4371 (e.g., the dielectric 4371a positioned in the core portion 4371 of FIG. 4A) and the interposer substrate 4301 may have different coefficients of thermal expansion. Both sides of the dielectric 4371a may be substantially exposed to the outside through the first opening 4330 and the second opening 4340, and so the risk of cracks occurring due to different coefficients of thermal expansion may be prevented or reduced as there is space available for (thermal) expansion due to the exposure of the core portion 4371 to the first opening 4330 and/or the first gap 4362.

In an embodiment, the boundary portion 4372 may be positioned to enclose the core portion 4371 in a direction parallel to the height direction of the core portion 4371. In an embodiment, the boundary portion 4372 of the second via 437 may include a plating layer enclosing the dielectric 4371a. In an embodiment, the boundary portion 4372 of the second via 437 may overlap one or more first vias 436 based on the direction facing the first surface 4301a of the interposer 430.

In an embodiment, the boundary portion 4372 may overlap one or more third vias 438 based on the direction facing the second surface 4301b of the interposer 430. The first via 436 and the third via 438 may be disposed to overlap the boundary portion 4372 of the second via 437 and may be disposed not to overlap the first opening 4330 of the second pad 433 and the second opening 4340 of the third pad 434. The first via 436 disposed to overlap the boundary portion 4372 may connect the first pad 432 to the second pad 433, and the third via 438 disposed to overlap the boundary portion 4372 may connect the third pad 434 to the fourth pad 435, thereby increasing the structural stability of the interposer 430. The first via 436 may be connected to the second pad 433 so as not to overlap the first opening 4330 in the first connecting region 4361, may prevent or reduce the occurrence of cracks due to thermal expansion of the dielectric 4371a, and may prevent structural stability from being deteriorated by the cracks even when cracks occur. The third via 438 may be connected to the third pad 434 so as not to overlap the second opening 4340 in the second connecting region 4381, may prevent or reduce the occurrence of cracks due to thermal expansion of the dielectric 4371a, and may prevent structural stability from being deteriorated by the cracks even when cracks occur.

In an embodiment, a diameter 4372a of the boundary portion 4372 may be about 220 µm or less, based on a cross-section (e.g., the XY plane of FIG. 4C) perpendicular to the height direction (e.g., the Z-axis direction of FIG. 4C) of the interposer 430. As used herein, the terms "substantially", "approximately", "generally", and "about" in reference to a given parameter, property, or condition may include a degree that one of ordinary skill in the art would understand that the given parameter, property, or condition is met with a small degree of variance, such as within acceptable manufacturing tolerances. For example, a parameter that is substantially met may be at least 90% met, at least 95% met, or at least 99% met. In an embodiment, a diameter 433a of the second pad 433 may be at least 60 µm greater than the diameter 4372a of the boundary portion 4372. For example, the diameter 433a of the second pad 433 may be about 280 µm, about 285 µm, about 290 µm or more.

FIG. 5A is a cross-sectional view taken along the line I-I of FIG. 4A according to an embodiment. FIG. 5B is a cross-sectional view taken along the line II-II of FIG. 4A according to an embodiment. In the description of FIGs. 5A and 5B, unless otherwise specified, the description provided for FIGs. 1 to 4 may be equally applicable.

Referring to FIGS. 5A and 5B, an interposer (e.g., the interposer 430 of FIG. 4A) according to an embodiment may include a first pad 532 (e.g., the first pad 432 of FIG. 4A), a second pad 533 (e.g., the second pad 433 of FIG. 4A), and a first via 536 (e.g., the first via 436 of FIG. 4A) connecting the first pad 532 to the second pad 533. In an embodiment, each of a plurality of first vias 536a, 536b, and 536c may be connected to the first pad 532 so as to be in contact with the perimeter of the first pad 532.

In an embodiment, the first via 536 may be connected to the second pad 533 in a first connecting region 5361 (e.g., the first connecting region 4361 of FIG. 4A). In an embodiment, each of the plurality of first vias 536a, 536b, and 536c may be connected to the second pad 533 in each of a plurality of first connecting regions 5361a, 5361b, and 5361c. In an embodiment, each of the plurality of first connecting regions 5361a, 5361b, and 5361c may not overlap a first opening 5330 (e.g., the first opening 4330 of FIG. 4A) formed in a first body 5331 (e.g., the first body 4331 of FIG. 4A) of the second pad 533. In an embodiment, the first via 536 may be positioned to overlap a boundary portion 5372 (e.g., the boundary portion 4372 of FIG. 4A) of a second via (e.g., the second via 437 of FIG. 4A).

FIGS. 5A and 5B illustrate the first via 536 and do not illustrate a third via (e.g., the third via 438 of FIG. 4A), but it should be noted that the embodiments of FIGS. 5A and 5B may apply to the third via in the same manner.

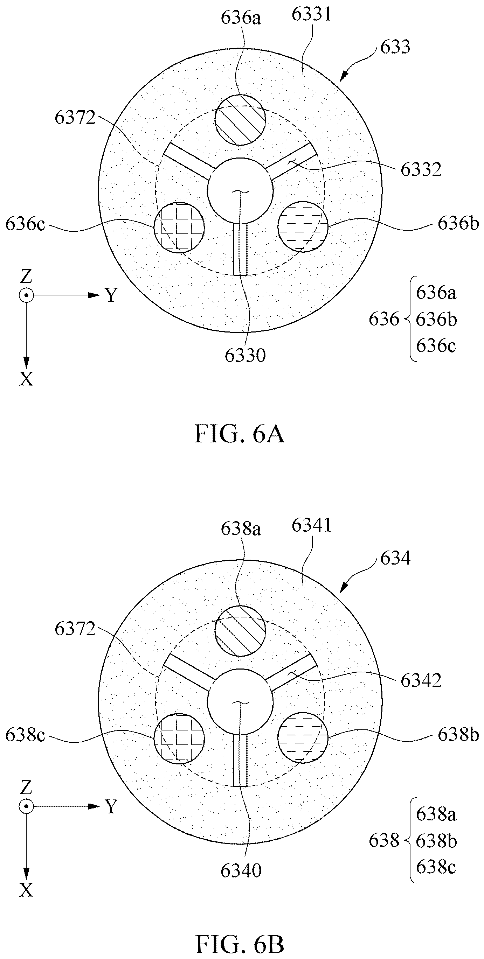

FIGS. 6A to 6C are diagrams illustrating embodiments in which the interposer according to FIG. 5B further includes an extension opening.

Referring to FIGS. 6A to 6C, an interposer (e.g., the interposer 430 of FIG. 4A) according to an embodiment may include a second pad 633 (e.g., the second pad 433 of FIG. 4A) positioned in the interposer, a third pad 634 (e.g., the third pad 434 of FIG. 4A), a plurality of first vias 636 (e.g., the plurality of first vias 536 of FIG. 5A) connected to the second pad 633, a plurality of third vias 638 (e.g., the plurality of third vias 438 of FIG. 4A) connected to the third pad 634, a first opening 6330 (e.g., the first opening 4330 of FIG. 4A) formed in the second pad 633, at least one first extension opening 6332 formed in the second pad 633, a second opening 6340 (e.g., the second opening 4340 of FIG. 4A) formed in the third pad 634, and at least one second extension opening 6342 formed in the third pad 634.

In an embodiment, the first extension opening 6332 may be formed through a first body 6331 (e.g., the first body 4331 of FIG. 4C) of the second pad 633. The first extension opening 6332 may extend from the circumference of the first opening 6330. In an embodiment, the first extension opening 6332 may be formed not to overlap each of the first vias 636a, 636b, and 636c disposed to overlap a boundary portion 6372 (e.g., the boundary portion 4372 of FIG. 4A) of a second via (e.g., the second via 437 of FIG. 4A). The first extension opening 6332 according to FIG. 6A is illustrated as being formed to extend in three directions from the first opening 6330, but this is only an example, and the first extension opening 6332 may be formed to extend in one, two, or four or more directions from the first opening 6330. The first extension opening 6332 is illustrated as being straight, but this is only an example, and the first extension opening 6332 may also be formed in a curved or spiral shape.

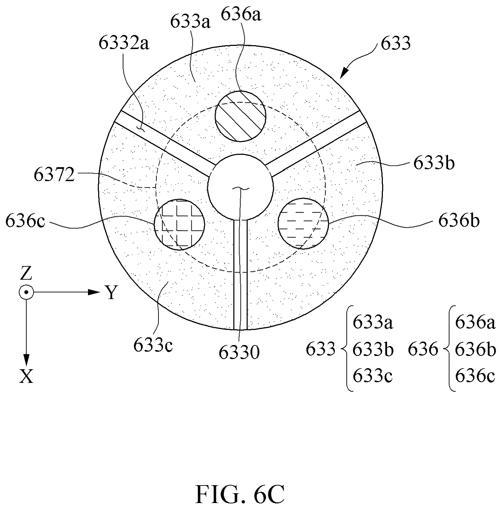

Referring to FIG. 6C, in an embodiment, a first extension opening 6332a may be formed to extend from the first opening 6330 to the perimeter of the second pad 633. In an embodiment, the second pad 633 may be divided into at least two parts 633a, 633b, and 633c by the first extension opening 6332a.

In an embodiment, the second extension opening 6342 may be formed through a second body 6341 (e.g., the second body 4341 of FIG. 4A) of the third pad 634. The second extension opening 6342 may extend from the circumference of the second opening 6340. In an embodiment, the second extension opening 6342 may be formed not to overlap each of the third vias 638a, 638b, and 638c disposed to overlap the boundary portion 6372 (e.g., the boundary portion 4372 of FIG. 4A) of the second via (e.g., the second via 437 of FIG. 4A). The second extension opening 6342 according to FIG. 6B is illustrated as being formed to extend in three directions from the second opening 6340, but this is only an example, and the second extension opening 6342 may be formed to extend in one, two, or four or more directions from the second opening 6340. The second extension opening 6342 is illustrated as being straight, but this is only an example, and the second extension opening 6342 may also be formed in a curved or spiral shape.

The first extension opening 6332 and the second extension opening 6342 according to an embodiment may increase the size of an opening formed in a pad of the interposer (e.g., the interposer 430 of FIG. 4A). In an embodiment, when the size of the opening increases, the risk of cracking due to expansion of a dielectric (e.g., the dielectric 4371a of FIG. 4A) positioned in the core portion (e.g., the core portion 4371 of FIG. 4A) of the second via (e.g., the second via 437 of FIG. 4A) positioned in the interposer may be prevented or reduced.

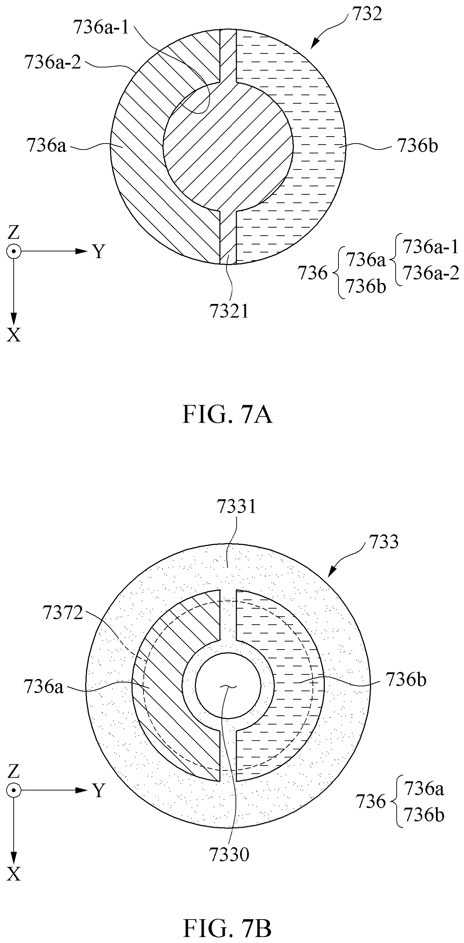

FIG. 7A is a cross-sectional view of an embodiment in which a via of an interposer is formed in an arc shape, as viewed from above, according to an embodiment. FIG. 7B is a cross-sectional view of the via of the interposer according to FIG. 7A, as viewed from below, according to an embodiment. Reference may be made to any of the preceding Figures and description therein.

Referring to FIGS. 7A and 7B, an interposer (e.g., the interposer 430 of FIG. 4A) may include a first pad 732 (e.g., the first pad 432 of FIG. 4A), a plurality of first vias 736 (e.g., the plurality of first vias 436 of FIG. 4A) connected to the first pad 732, a second pad 733 (e.g., the second pad 433 of FIG. 4A), a first opening 7330 (e.g., the first opening 4330 of FIG. 4A) formed in a first body 7331 (e.g., the first body 4331 of FIG. 4A) of the second pad 733, and a second via (e.g., the second via 437 of FIG. 4A).

In an embodiment, each of the plurality of first vias 736a and 736b may have an arc-shaped cross-section in which two arcs 736a-1 (e.g. forming an inner arc, or boundary, of the cross sectional arc) and 736a-2 (e.g. forming an outer arc, or boundary, of the cross sectional arc) are connected based on a cross-section (e.g., the XY plane of FIG. 7A) perpendicular to the height direction (e.g., the Z-axis direction of FIG. 7A) of the interposer. In an embodiment, the arc-shaped cross-section of the first via 736 may be formed to enclose (e.g. at least partially surround) the first opening 7330 formed in the second pad 733. In an embodiment, the arc-shaped cross-section of the first via 736 may be positioned not to overlap the first opening 7330 and overlap a boundary portion 7372 (e.g., the boundary portion 4372 of FIG. 4A) of the second via. In an embodiment, a third via (e.g., the third via 438 of FIG. 4A) may have substantially the same arc-shaped cross-section as the first via 736. In an embodiment, when the first via 736 and the third via have arc-shaped cross-sections, the area of a via that is in contact with the first pad 732, the second pad 733, the third pad (e.g., the third pad 434 of FIG. 4A), and the fourth pad (e.g., the fourth pad 435 of FIG. 4A) of the interposer may increase. As the contact area of the via to the pad of the interposer increases, the structural stability of the interposer may be increased.

In an embodiment, the first via 736 is illustrated as two vias 736a and 736b having arc-shaped cross-sections, but this is only an example, and the number of first vias 736 may be one, two, three or more. In an embodiment, the first via 736 may have an integral arc-shaped cross-section enclosing the first opening 7330 with respect to a cross-section perpendicular to the height direction. In an embodiment, the number of third vias (e.g., the third via 438 of FIG. 4A) may be one, two, three or more. For example, the third via may have an integral arc-shaped cross-section enclosing the second opening (e.g., the second opening 4340 of FIG. 4A) with respect to the cross-section perpendicular to the height direction.

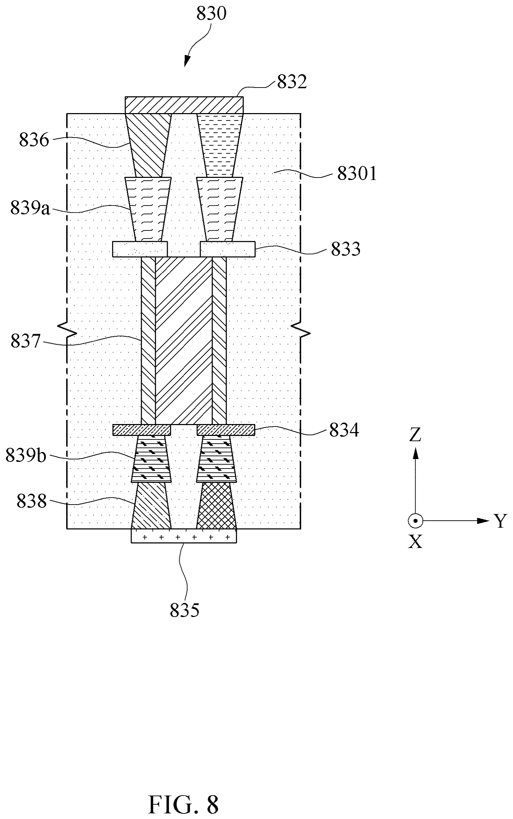

FIG. 8 is a cross-sectional view of an interposer including a plurality of stacked vias, according to an embodiment.

Referring to FIG. 8, an interposer 830 (e.g., the interposer 430 of FIG. 4A) according to an embodiment may include an interposer substrate 8301 (e.g., the interposer substrate 4301 of FIG. 4A), a first pad 832 (e.g., the first pad 432 of FIG. 4A) and a fourth pad 835 (e.g., the fourth pad 435 of FIG. 4A) at least partially exposed to the outside of the interposer, a second pad 833 (e.g., the second pad 433 of FIG. 4A) and a third pad 834 (e.g., the third pad 434 of FIG. 4A) disposed in the interposer, a first via 836 (e.g., the first via 436 of FIG. 4A) and a first stacked via 839a connecting the first pad 832 to the second pad 833, a second via 837 (e.g., the second via 437 of FIG. 4A) connecting the second pad 833 to the third pad 834, and a third via 838 (e.g., the third via 438 of FIG. 4A) and a second stacked via 839b connecting the third pad 834 to the fourth pad 835.

In an embodiment, the first stacked via 839a may be stacked in the height direction (e.g., the Z-axis direction of FIG. 8) of the interposer between the first via 836 and the second pad 833. In an embodiment, the second stacked via 839b may be stacked in the height direction of the interposer between the third pad 834 and the third via 838. In an embodiment, the number of first stacked vias 839a and the number of second stacked vias 839b may be one, two, three or more. In an embodiment, the first stacked via 839a may increase the distance between the first pad 832 and the second pad 833. In an embodiment, the second stacked via 839b may increase the distance between the third pad 834 and the fourth pad 835. In an embodiment, increasing the distance between pads of the interposer may reduce signal interference and facilitate thermal management.

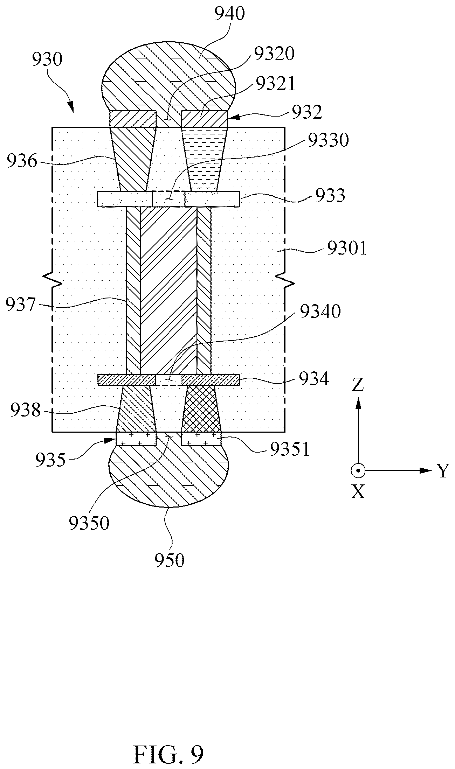

FIG. 9 is a diagram illustrating an opening formed in a first pad and a fourth pad according to an embodiment and a plurality of bonding members disposed to enclose the opening.

Referring to FIG. 9, a PCB (e.g., the PCB 300 of FIG. 3A) according to an embodiment may include a first circuit board (e.g., the first circuit board 310 of FIG. 3A), a second circuit board (e.g., the second circuit board 320 of FIG. 3A), an interposer 930 (e.g., the interposer 430 of FIG. 4A), a first bonding member 940 (e.g., the first bonding member 340 of FIG. 3A), and a second bonding member 950 (e.g., the second bonding member 350 of FIG. 3A).

The interposer 930 according to an embodiment may include an interposer substrate 9301 (e.g., the interposer substrate 4301 of FIG. 4A), a first pad 932 (e.g., the first pad 432 of FIG. 4A) and a fourth pad 935 (e.g., the fourth pad 435 of FIG. 4A) at least partially exposed to the outside of the interposer 930, a second pad 933 (e.g., the second pad 433 of FIG. 4A) and a third pad 934 (e.g., the third pad 434 of FIG. 4A) disposed in the interposer 930, a first via 936 (e.g., the first via 436 of FIG. 4A) connecting the first pad 932 to the second pad 933, a second via 937 (e.g., the second via 437 of FIG. 4A) connecting the second pad 933 to the third pad 934, and a third via 938 (e.g., the third via 438 of FIG. 4A) connecting the third pad 934 to the fourth pad 935. In an embodiment, a first opening 9330 (e.g., the first opening 4330 of FIG. 4A) may be formed in the second pad 933. In an embodiment, the first bonding member 940 (e.g., the first bonding member 340 of FIG. 3A) may connect the first circuit board (e.g., the first circuit board 310 of FIG. 3A) to the first pad 932 of the interposer 930. In an embodiment, the first bonding member 940 may be in contact with the first pad 932. In an embodiment, the second bonding member 950 (e.g., the second bonding member 350 of FIG. 3A) may connect the second circuit board (e.g., the second circuit board 320 of FIG. 3A) to the fourth pad 935 of the interposer 930. In an embodiment, the second bonding member 950 may be in contact with the fourth pad 935.

In an embodiment, the first pad 932 may include a third body 9321 and a third opening 9320 formed through the third body 9321. According to an embodiment, the first bonding member 940 may be disposed in the third opening 9320. For example, the first bonding member 940 may be disposed to enclose the third opening 9320.

In an embodiment, the fourth pad 935 may include a fourth body 9351 and a fourth opening 9350 formed through the fourth body 9351. According to an embodiment, the second bonding member 950 may be disposed in the fourth opening 9350. For example, the second bonding member 950 may be disposed to enclose the fourth opening 9350.

In an embodiment, based on the direction (e.g., the Z-axis direction of FIG. 9) facing a first surface (e.g., the first surface 4301a of FIG. 4A) of the interposer 930, the third opening 9320 formed in the first pad 932 and the first opening 9330 formed in the second pad 933 may at least partially overlap each other. In an embodiment, based on the direction facing the first surface of the interposer 930, the second opening 9340 formed in the third pad 934 and the fourth opening 9350 formed in the fourth pad 935 may at least partially overlap each other.

In an embodiment, an interposer 330, 430, 830, or 930 of an electronic device 201 may include an interposer substrate 4301, 8301, or 9301 including a first surface 4301a and a second surface 4301b that is opposite to the first surface 4301a, a first pad 432, 532, 732, 832, or 932 disposed on the first surface 4301a, a second pad 433, 533, 633, 733, 833, or 933 spaced apart from the first pad 432, 532, 732, 832, or 932 and disposed in the interposer substrate 4301, 8301, or 9301, a third pad 434, 634, 834, or 934 spaced apart from the second pad 433, 533, 633, 733, 833, or 933 and disposed in the interposer substrate 4301, 8301, or 9301, a fourth pad 435, 835, or 935 spaced apart from the third pad 434, 634, 834, or 934 and disposed on the second surface 4301b, a first via 436, 536, 636, 736, 836, or 936 configured to connect the first pad 432, 532, 732, 832, or 932 to the second pad 433, 533, 633, 733, 833, or 933, a second via 437, 837, or 937 configured to connect the second pad 433, 533, 633, 733, 833, or 933 to the third pad 434, 634, 834, or 934, and a third via 438, 638, 838, or 938 configured to connect the third pad 434, 634, 834, or 934 to the fourth pad 435, 835, or 935, wherein the second via 437, 837, or 937 may include a core portion 4371 having a height direction and a boundary portion 4372, 6372, or 7372 positioned to enclose the core portion 4371 in the height direction, when the first surface 4301a is viewed, a first connecting region 4361 or 5361 in which the first via 436, 536, 636, 736, 836, or 936 is connected to the second pad 433, 533, 633, 733, 833, or 933 may overlap the boundary portion 4372, 6372, or 7372, and a second connecting region 4381 in which the third via 438, 638, 838, or 938 is connected to the third pad 434, 634, 834, or 934 may overlap the boundary portion 4372, 6372, or 7372.

In an embodiment, the second pad 433, 533, 633, 733, 833, or 933 may include a first body 4331, 5331, 6331, or 7331 and a first opening 4330, 5330, 6330, 7330, or 9330 passing through the first body 4331, 5331, 6331, or 7331 and overlapping the core portion 4371 when the first surface 4301a is viewed, and the third pad 434, 634, 834, or 934 may include a second body 4341 or 6341 and a second opening 4340, 6340, or 9340 passing through the second body 4341 or 6341) and overlapping the core portion 4371 when the first surface 4301a is viewed.

In an embodiment, the first connecting region 4361 or 5361 may not overlap the first opening 4330, 5330, 6330, 7330, or 9330, and the second connecting region 4381 may not overlap the second opening 4340, 6340, or 9340.

In an embodiment, a plurality of first vias 436, 536, 636, 736, 836, and 936 and a plurality of third vias 438, 638, 838, and 938 are provided, and each of a plurality of first connecting regions 4361 or 5361 in which the plurality of first vias 436, 536, 636, 736, 836, and 936 is connected to the second pad 433, 533, 633, 733, 833, or 933 may not overlap the first opening 4330, 5330, 6330, 7330, or 9330, and each of a plurality of second connecting regions 4381 in which the plurality of third vias 438, 638, 838, and 938 is connected to the third pad 434, 634, 834, or 934 may not overlap the second opening 4340, 6340, or 9340.

In an embodiment, a first gap 4362 may be formed between the plurality of first vias 436, 536, 636, 736, 836, and 936, a second gap 4382 may be formed between the plurality of third vias 438, 638, 838, or 938, and the first gap 4362 may overlap the first opening 4330, 5330, 6330, 7330, or 9330, and the second gap 4382 may overlap the second opening 4340, 6340, or 9340.

In an embodiment, each of the first vias 736 and each of the third vias 438, 838, or 938 may have an arc-shaped cross-section to which two arcs 736a-1 and 736a-2 are connected, based on a cross-section perpendicular to the height direction.

In an embodiment, a dielectric 4371a may be positioned in the core portion 4371, and the dielectric 4371a may be exposed to the outside through the first opening 4330, 5330, 6330, 7330, or 9330 and the second opening 4340, 6340, or 9340.

In an embodiment, the second pad 633 may further include a first extension opening 6332 passing through the first body 6331 and extending from the circumference of the first opening 6330, and the third pad 634 may further include a second extension opening 6342 passing through the second body 6341 and extending from the circumference of the second opening 6340.

In an embodiment, the first pad 932 may include a third body 9321 and a third opening 9320 passing through the third body 9321, and the fourth pad 935 may include a fourth body 9351 and a fourth opening 9350 passing through the fourth body 9351.

In an embodiment, when the first surface 4301a is viewed, the first opening 9330 and the third opening 9320 may overlap to each other, and the second opening 9340 and the fourth opening 9350 may overlap each other.

In an embodiment, the first via 436, 536, 636, 736, 836, or 936 may have an integral arc-shaped cross-section enclosing the first opening 4330, 5330, 6330, 7330, or 9330 based on a cross-section perpendicular to the height direction, and the third via 438, 638, 838, or 938 may have an integral arc-shaped cross-section enclosing the second opening 4340, 6340, or 9340 based on the cross-section perpendicular to the height direction.

In an embodiment, when the first surface 4301a is viewed, the first pad 432, 532, 732, 832, or 932, the second pad 433, 533, 633, 733, 833, or 933, the third pad 434, 634, 834, or 934, and the fourth pad 435, 835, or 935 may at least partially overlap one another, and when the first surface 4301a is viewed, the first via 436, 536, 636, 736, 836, or 936 and the third via 438, 638, 838, or 938 may overlap each other.

In an embodiment, based on the cross-section perpendicular to the height direction, the first via 436, 536, 636, 736, 836, or 936 may be positioned to be in contact with at least a portion of the perimeter of the first pad 432, 532, 732, 832, or 932, and the third via 438, 638, 838, or 938 may be positioned to be in contact with at least a portion of the perimeter of the fourth pad 435, 835, or 935.

In an embodiment, based on the cross-section perpendicular to the height direction, the first via 436, 536, 636, 736, 836, or 936 and the third via 438, 638, 838, or 938 may each have a cross-sectional shape of any one of a circle, an ellipse, and a polygon.

In an embodiment, a via structure may further include one or more first stacked vias 839a stacked between the first via 436, 536, 636, 736, 836, or 936 and the second pad 433, 533, 633, 733, 833, or 933 in the height direction, and one or more second stacked vias 839b stacked between the third pad 434, 634, 834, or 934 and the third via 438, 638, 838, or 938 in the height direction.

In an embodiment, based on the cross-section perpendicular to the height direction, the diameter 4372a of the boundary portion 4372, 6372, or 7372 is less than or equal to 220 µm, and the diameter 433a of the second pad 433, 533, 633, 733, 833, or 933 may be at least 60 µm greater than the diameter 4372a of the boundary portion 4372, 6372, or 7372.

In an embodiment, the distance between the central axis X1 of the first via 436, 536, 636, 736, 836, or 936 and the central axis X2 of the second via 437, 837, or 937 may be less than or equal to 220 µm.

In an embodiment, based on the cross-section perpendicular to the height direction, the area of the third connecting region 4363 in which the first via 436, 536, 636, 736, 836, or 936 is connected to the first pad 432, 532, 732, 832, or 932 may be greater than the area of the first connecting region 4361 or 5361.

In an embodiment, an electronic device 201 may include a housing 210 and a PCB 300 disposed in an internal space of the housing 210, wherein the PCB 300 may include a first circuit board 310, a second circuit board 320, and one or more interposers 330, 430, 830, and 930 disposed between the first circuit board 310 and the second circuit board 320 and configured to connect the first circuit board 310 to the second circuit board 320 in a height direction, wherein the one or more interposers 330, 430, 830, and 930 may include an interposer substrate 4301, 8301, or 9301 including a first surface 4301a and a second surface 4301b that is opposite to the first surface 4301a, a first pad 432, 532, 732, 832, or 932 disposed on the first surface 4301a and facing the first circuit board 310, a second pad 433, 533, 633, 733, 833, or 933 spaced apart from the first pad 432, 532, 732, 832, or 932 and disposed in the interposer substrate 4301, 8301, or 9301, a third pad 434, 634, 834, or 934 spaced apart from the second pad 433, 533, 633, 733, 833, or 933 and disposed in the interposer substrate 4301, 8301, or 9301, a fourth pad 435, 835, or 935 spaced apart from the third pad 434, 634, 834, or 934, disposed on the second surface 4301b, and facing the second circuit board 320, a first via 436, 536, 636, 736, 836, or 936 connecting the first pad 432, 532, 732, 832, or 932 to the second pad 433, 533, 633, 733, 833, or 933, a second via 437, 837, or 937 connecting the second pad 433, 533, 633, 733, 833, or 933 to the third pad 434, 634, 834, or 934, and a third via 438, 638, 838, or 938 connecting the third pad 434, 634, 834, or 934 to the fourth pad 435, 835, or 935, wherein the second via 437, 837, or 937 may include a core portion 4371 in which a dielectric 4371a is positioned in a height direction and a boundary portion 4372, 6372, or 7372 positioned to enclose the core portion 4371 in the height direction, when the first surface 4301a is viewed, a first connecting region 4361 or 5361 in which the first via 436, 536, 636, 736, 836, or 936 is connected to the second pad 433, 533, 633, 733, 833, or 933 may overlap the boundary portion 4372, 6372, or 7372, and a second connecting region 4381 in which the third via 438, 638, 838, or 938 is connected to the third pad 434, 634, 834, or 934 may overlap the boundary portion 4372, 6372, or 7372.

In an embodiment, the second pad 433, 533, 633, 733, 833, or 933 may include a first body 4331, 5331, 6331, or 7331 and a first opening 4330, 5330, 6330, 7330, or 9330 passing through the first body 4331, 5331, 6331, or 7331 and overlapping the core portion 4371 when the first surface 4301a is viewed, the third pad 434, 634, 834, or 934 may include a second body 4341 or 6341 and a second opening 4340, 6340, or 9340 passing through the second body 4341 or 6341 and overlapping the core portion 4371 when the first surface 4301a is viewed, a plurality of first vias 436, 536, 636, 736, 836, and 936 and a plurality of third vias 438, 638, 838, and 938 are provided, each of the plurality of first connecting regions 4361 or 5361 in which the plurality of first vias 436, 536, 636, 736, 836, and 936 is connected to the second pad 433, 533, 633, 733, 833, or 933 may not overlap the first opening 4330, 5330, 6330, 7330, or 9330, each of the plurality of second connecting regions 4381 in which the plurality of third vias 438, 638, 838, and 938 is connected to the third pad 434, 634, 834, or 934 may not overlap the second opening 4340, 6340, or 9340, and the dielectric 4371a may be exposed to the outside through the first opening 4330, 5330, 6330, 7330, or 9330 and the second opening 4340, 6340, or 9340.

In an embodiment, the electronic device 201 may further include a first bonding member 340 or 940 configured to connect the first circuit board 310 to the interposer 330, 430, 830, or 930 and a second bonding member 350 or 950 configured to connect the second circuit board 320 to the interposer 330, 430, 830, or 930.

In an embodiment, the first bonding member 340 or 940 may be in contact with the first pad 432, 532, 732, 832, or 932, the second bonding member 350 or 950 may be in contact with the fourth pad 435, 835, or 935, the first pad 432, 532, 732, 832, or 932 may include a third body 4321, 7321, or 9321 and a third opening 9320 passing through the third body 4321, 7321, or 9321, the fourth pad 435, 835, or 935 may include a fourth body 9351 and the fourth opening 9350 passing through the fourth body 9351, the first bonding member 340 or 940 may be disposed to enclose the third opening 9320 of the first pad 432, 532, 732, 832, or 932, and the second bonding member 350 or 950 may be disposed to enclose the fourth opening 9350 of the fourth pad 435, 835, or 935.

In an embodiment, an interposer 330, 430, 830, or 930 of an electronic device 201 may include an interposer substrate 4301, 8301, or 9301 including a first surface 4301a and a second surface 4301b that is opposite to the first surface 4301a, a first pad 432, 532, 732, 832, or 932 disposed on the first surface 4301a, a second pad 433, 533, 633, 733, 833, or 933 spaced apart from the first pad 432, 532, 732, 832, or 932 and disposed in the interposer substrate 4301, 8301, or 9301, a third pad 434, 634, 834, 934 spaced apart from the second pad 433, 533, 633, 733, 833, or 933 and disposed in the interposer substrate 4301, 8301, or 9301, a fourth pad 435, 835, or 935 spaced apart from the third pad 434, 634, 834, or 934 and disposed on the second surface 4301b, a plurality of first vias 436, 536, 636, 736, 836, and 936 connecting the first pad 432, 532, 732, 832, or 932 to the second pad 433, 533, 633, 733, 833, or 933, a second via 437, 837, or 937 connecting the second pad 433, 533, 633, 733, 833, or 933 to the third pad 434, 634, 834, or 934, and a plurality of third vias 438, 638, 838, and 938 connecting the third pad 434, 634, 834, or 934 to the fourth pad 435, 835, or 935, wherein the second via 437, 837, or 937 may include a core portion 4371 having a height direction and a boundary portion 4372, 6372, or 7372 positioned to enclose the core portion 4371 in the height direction, the second pad 433, 533, 633, 733, 833, or 933 may include a first body 4331, 5331, 6331, or 7331 and a first opening 4330, 5330, 6330, 7330, or 9330 passing through the first body 4331, 5331, 6331, or 7331 and overlapping the core portion 4371 when the first surface 4301a is viewed, the third pad 434, 634, 834, or 934 may include a second body 4341 or 6341 and a second opening 4340, 6340, or 9340 passing through the second body 4341 or 6341 and overlapping the core portion 4371 when the first surface 4301a is viewed, when the first surface 4301a is viewed, each of the plurality of first connecting regions 4361 and 5361 in which the plurality of first vias 436, 536, 636, 736, 836, and 936 is connected to the second pad 433, 533, 633, 733, 833, or 933 may overlap the boundary portion 4372, 6372, or 7372, each of the plurality of second connecting regions 4381 in which the plurality of third vias 438, 638, 838, and 938 is connected to the third pad 434, 634, 834, or 934 may overlap the boundary portion 4372, 6372, or 7372, each of the plurality of first connecting regions 4361 and 5361 may not overlap the first opening 4330, 5330, 6330, 7330, or 9330, and each of the plurality of second connecting regions 4381 may not overlap the second opening 4340, 6340, or 9340.

In an embodiment, a PCB 300 may include a plurality of via structures 331 including a first via structure 331a and a second via structure 331b for electrically connecting one side and an opposite side of the PCB 300 and an interposer substrate 4301, 8301, or 9301 including a first surface 4301a and a second surface 4301b that is opposite to the first surface 4301a. The first via structure 331a may include a first pad 432, 532, 732, 832, or 932 formed on the first surface 4301a of the interposer substrate 4301, 8301, or 9301, a fourth pad 435, 835, or 935 formed on the second surface 4301b that is opposite to the first surface 4301a, a second pad 433, 533, 633, 733, 833, or 933 formed in the interposer substrate 4301, 8301, or 9301 closer to the first pad 432, 532, 732, 832, or 932 than the fourth pad 435, 835, or 935, a third pad 434, 634, 834, or 934 formed in the interposer substrate 4301, 8301, or 9301 closer to the fourth pad 435, 835, or 935 than the first pad 432, 532, 732, 832, or 932, a second via 437, 837, or 937 connected to the second pad 433, 533, 633, 733, 833, or 933 and the third pad 434, 634, 834, or 934, a plurality of first vias 436, 536, 636, 736, 836, and 936 connected to the first pad 432, 532, 732, 832, or 932 and the second pad 433, 533, 633, 733, 833, or 933, and a plurality of third vias 438, 638, 838, and 938 connected to the fourth pad 435, 835, or 935 and the third pad 434, 634, 834, or 934. The second pad 433, 533, 633, 733, 833, or 933 may include a first opening 4330, 5330, 6330, 7330, or 9330 formed between the plurality of first vias 436, 536, 636, 736, 836, and 936 and connected to the inside of the second via 437, 837, or 937.

In an embodiment, the second via 437, 837, or 937 may include a boundary portion 4372, 6372, or 7372 forming a boundary of the second via 437, 837, or 937, and at least one of the plurality of first vias 436, 536, 636, 736, 836, and 936 may be formed to overlap at least a portion of the boundary portion 4372, 6372, or 7372.

In an embodiment, the first opening 4330, 5330, 6330, 7330, or 9330 may include a first extension opening 6332 or 6332a formed in a portion of the boundary portion 4372, 6372, or 7372.

In an embodiment, the internal space of the boundary portion 4372, 6372, or 7372 may be filled with a core portion 4371 formed of a non-conductive material, and a portion of the core portion 4371 may be exposed between the plurality of first vias 436, 536, 636, 736, 836, and 936 through the first opening 4330, 5330, 6330, 7330, or 9330.

In an embodiment, the diameter of the boundary portion 4372, 6372, or 7372 may be less than or equal to 220 µm, and the diameter of the second pad 433, 533, 633, 733, 833, or 933 may be at least 60 µm greater than the diameter of the boundary portion 4372, 6372, or 7372.

In an embodiment, the distance between the central axis X1 of the first via structure 331a and the central axis X2 of the second via structure 331b may be less than or equal to 550 µm.

In an embodiment, the area of a region in which at least one of the plurality of first vias 436, 536, 636, 736, 836, and 936 is connected to the first pad 432, 532, 732, 832, or 932 may be formed to be greater than the area of a region in which at least one of the plurality of first vias 436, 536, 636, 736, 836, and 936 meets the second pad 433, 533, 633, 733, 833, or 933.

In an embodiment, the third pad 434, 634, 834, or 934 may include a second opening 4340, 6340, or 9340 formed between the plurality of third vias 438, 638, 838, and 938 and connected to the inside of the second via 437, 837, or 937.

In an embodiment, the interposer substrate 4301, 8301, or 9301 may form at least a portion of an interposer.

Additional embodiments in accordance with the present disclosure are described below.

Paragraph 1. An interposer (330; 430; 830; 930) for connecting printed circuit boards (PCBs), the interposer comprising: an interposer substrate (4301; 8301; 9301) comprising a first surface (4301a) and a second surface (4301b) that is opposite to the first surface (4301a); and at least one via structure (331; 331a; 331b; 431) disposed on (e.g., that extends through) the interposer substrate (4301; 8301; 9301), wherein the at least one via structure (331; 331a; 331b; 431) comprises: a first pad (432; 532; 732; 832; 932) disposed on the first surface (4301a); a second pad (433; 533; 633; 733; 833; 933) spaced apart from the first pad (432; 532; 732; 832; 932) and disposed in the interposer substrate (4301; 8301; 9301); a third pad (434; 634; 834; 934) spaced apart (e.g., in a direction of the second surface 4301b) from the second pad (433; 533; 633; 733; 833; 933); at least one first via (436; 536; 636; 736; 836; 936) disposed between the first pad (432; 532; 732; 832; 932) and the second pad (433; 533; 633; 733; 833; 933); and a second via (437; 837; 937) disposed between (e.g., that extends between) the second pad (433; 533; 633; 733; 833; 933) and the third pad (434; 634; 834; 934), wherein the second pad (433; 533; 633; 733; 933) comprises a first body (4331; 5331; 6331; 7331) and at least one first opening (4330; 5330; 6330; 7330; 9330) passing through the first body, and wherein the at least one first via is connected to the first body (4331; 5331; 6331; 7331) of the second pad (433; 533; 633; 733; 833; 933).

Paragraph 2. The interposer (330; 430; 830; 930) of paragraph 1, wherein the second via (437; 837; 937) comprises: a core portion (4371) having a height direction (e.g., extending in a height direction of the interposer substrate between the second pad and third pad); and a boundary portion (4372; 6372; 7372) positioned (e.g., configured to) to enclose the core portion (4371) in the height direction, and when the first surface is viewed (e.g., from the first surface), the first opening (4330; 5330; 6330; 7330; 9330) of the second pad (433; 533; 633; 733; 833; 933) at least partially overlaps the core portion.

Paragraph 3. The interposer (330; 430; 830; 930) of paragraph 1 or 2, wherein the core portion (4371) and the interposer substrate (4301; 8301; 9301) (e.g. the materials thereof) have different coefficients of thermal expansion.

Paragraph 4. The interposer (330; 430; 830; 930) of one of paragraphs 1 to 3, wherein a dielectric (4371a) is positioned in the core portion (4371), and the dielectric (4371a) is exposed to an outside through the first opening (4330; 5330; 6330; 7330; 9330).

Paragraph 5. The interposer (330; 430; 830; 930) of one of paragraphs 1 to 4, wherein a plurality of first vias (436; 536; 636; 736; 836; 936) is provided, and each of the plurality of first vias (436; 536; 636; 736; 836; 936) is connected to the first body of the second pad.

Paragraph 6. The interposer (330; 430; 830; 930) of one of paragraphs 1 to 5, wherein the third pad (434; 634; 834; 934) is disposed in the interposer substrate (4301; 8301; 9301), the at least one via structure (331; 331a; 331b; 431) further comprises: a fourth pad (435; 835; 935) spaced apart from the third pad (434; 634; 834; 934) and disposed on the second surface (4301b); and at least one third via (438; 638; 838; 938) disposed between the third pad (434; 634; 834; 934) and the fourth pad (435; 835; 935), and the third pad (434; 634; 834; 934) comprises: a second body (4341; 6341), wherein the at least one third via (438; 638; 838; 938) is connected to the second body (4341; 6341); and at least one second opening (4340; 6340; 9340) passing through the second body (4341; 6341).

Paragraph 7. The interposer (330; 430; 830; 930) of one of paragraphs 1 to 6, wherein, based on a cross-section perpendicular to a height direction of the first via 736, the first via 736 has an arc-shaped cross-section to which two arcs (736a-1; 736a-2) are connected.

Paragraph 8. The interposer (330; 430; 830; 930) of one of paragraphs 1 to 7, wherein the second pad (633) further comprises: a first extension opening (6332; 6332a) passing through the first body (6331) and extending from a circumference of the first opening (6330).

Paragraph 9. The interposer (330; 430; 830; 930) of one of paragraphs 1 to 8, wherein the second pad (633) is divided into at least two parts (633a; 633b; 633c) by the first extension opening (6332a).

Paragraph 10. The interposer (330; 430; 830; 930) of one of paragraphs 1 to 9, wherein the first pad (932) comprises: a third body (9321); and a third opening (9320) passing through the third body (9321).

Paragraph 11. The interposer (330; 430; 830; 930) of one of paragraphs 1 to 10, wherein the via structure (331; 331a; 331b; 431) further comprises: at least one first stacked via (839a) stacked between the first via (436; 536; 636; 736; 836; 936) and the second pad (433; 533; 633; 733; 833; 933) in a heigh direction.

Paragraph 12. The interposer (330; 430; 830; 930) of one of paragraphs 1 to 11, wherein, based on a cross-section perpendicular to the height direction, a diameter (4372a) of the boundary portion (4372; 6372; 7372) is less than or equal to 220 micrometers (µm), and a diameter (433a) of the second pad (433; 533; 633; 733; 833; 933) is at least 60 µm greater than the diameter (4372a) of the boundary portion (4372; 6372; 7372).

Paragraph 13. The interposer (330; 430; 830; 930) of one of paragraph 1 to 12, wherein a plurality of via structures (331; 331a; 331b; 431) is provided, and a distance (D1) between central axes (X1; X2) of the plurality of via structures (331; 331a; 331b; 431) is less than or equal to 550 µm.

Paragraph 14. The interposer (330; 430; 830; 930) of one of paragraphs 1 to 13, wherein an area of a third connecting region (4363) in which the first via (436; 536; 636; 736; 836; 936) is connected to the first pad (432; 532; 732; 832; 932) is greater than an area of a first connecting region (4361; 5361) in which the first via (436; 536; 636; 736; 836; 936) is connected to the second pad (433; 533; 633; 733; 833; 933).

Paragraph 15. The interposer (330; 430; 830; 930) of one of paragraphs 1 to 14, wherein the first via (436; 536; 636; 736; 836; 936) is formed by laser processing, and the second via (437; 837; 937) is formed by drill processing.

Paragraph 16. An electronic device (201) comprising: a housing (210); and a printed circuit board (PCB) (300) disposed in an inner space of the housing (210), wherein the PCB (300) comprises: a first circuit board (310); a second circuit board (320); and one or more interposers (330; 430; 830; 930) disposed between the first circuit board (310) and the second circuit board (320) and configured to connect the first circuit board (310) to the second circuit board (320) in a height direction (e.g., in a height direction of the interposer/PCB, a PCB stack), wherein the one or more interposers (330; 430; 830; 930) comprise: an interposer substrate (4301; 8301; 9301) comprising a first surface (4301a) and a second surface (4301b) that is opposite to the first surface (4301a); and at least one via structure (331; 331a; 331b; 431) disposed on the interposer substrate (4301; 8301; 9301), wherein the via structure (331; 331a; 331b; 431) comprises: a first pad (432; 532; 732; 832; 932) disposed on the first surface (4301a) and facing the first circuit board (310); a second pad (433; 533; 633; 733; 833; 933) spaced apart from the first pad (432; 532; 732; 832; 932) and disposed in the interposer substrate (4301; 8301; 9301); a third pad (434; 634; 834; 934) spaced part from the second pad (433; 533; 633; 733; 833; 933) and disposed in the interposer substrate (4301; 8301; 9301); a fourth pad (435; 835; 935) spaced apart from the third pad (434; 634; 834; 934), disposed on the second surface (4301b), and facing the second circuit board (320); a first via disposed between the first pad (432; 532; 732; 832; 932) and the second pad (433; 533; 633; 733; 833; 933); a second via (437; 837; 937) disposed between the second pad (433; 533; 633; 733; 833; 933) and the third pad (434; 634; 834; 934); and a third via (438; 638; 838; 938) disposed between the third pad (434; 634; 834; 934) and the fourth pad (435; 835; 935), wherein the second via (437; 837; 937) comprises: a core portion (4371) in which a dielectric (4371a) is positioned in the height direction; and a boundary portion (4372; 6372; 7372) positioned to enclose the core portion (4371) in the height direction, and wherein, when the first surface (4301a) is viewed, a first connecting region (4361; 5361) in which the first via (436; 536; 636; 736; 836; 936) is connected to the second pad (433; 533; 633; 733; 833; 933) overlaps the boundary portion (4372; 6372; 7372), and a second connecting region (4381) in which the third via (438; 638; 838; 938) is connected to the third pad (434; 634; 834; 934) overlaps the boundary portion (4372; 6372; 7372).

Paragraph 17. The electronic device of paragraph 16, wherein the second pad (433; 533; 633; 733; 833; 933) comprises: a first body (4331; 5331; 6331; 7331); and a first opening (4330; 5330; 6330; 7330; 9330) passing through the first body (4331; 5331; 6331; 7331) and overlapping the core portion (4371) when the first surface (4301a) is viewed, the third pad (434; 634; 834; 934) comprises: a second body (4341; 6341); and a second opening (4340; 6340; 9340) passing through the second body (4341; 6341) and overlapping the core portion (4371) when the first surface (4301a) is viewed, a plurality of first vias (436; 536; 636; 736; 836; 936) and a plurality of third vias (438; 638; 838; 938) are provided, each of a plurality of first connecting regions (4361; 5361) in which the plurality of first vias (436; 536; 636; 736; 836; 936) is connected to the second pad (433; 533; 633; 733; 833; 933) does not overlap the first opening (4330; 5330; 6330; 7330; 9330), each of a plurality of second connecting regions (4381) in which the plurality of third vias (438; 638; 838; 938) is connected to the third pad (434; 634; 834; 934) does not overlap the second opening (4340; 6340; 9340), and the dielectric (4371a) is exposed to an outside through the first opening (4330; 5330; 6330; 7330; 9330) and the second opening (4340; 6340; 9340).

Paragraph 18. The electronic device of paragraph 16 or 17, further comprising: a first bonding member (340; 940) configured to connect the first circuit substrate (310) to the interposer (330; 430; 830; 930); and a second bonding member (350; 950) configured to connect the second circuit substrate (320) to the interposer (330; 430; 830; 930).

Paragraph 19. The electronic device of one of paragraphs 16 to 18, wherein the first bonding member (340; 940) is in contact with the first pad (432; 532; 732; 832; 932), the second bonding member (350; 950) is in contact with the fourth pad (435; 835; 935), the first pad (432; 532; 732; 832; 932) comprises: a third body (4321; 7321; 9321); and a third opening (9320) passing through the third body (4321; 7321; 9321), the fourth pad (435; 835; 935) comprises: a fourth body (9351); and a fourth opening (9350) passing through the fourth body (9351), the first bonding member (340; 940) is disposed to enclose the third opening (9320) of the first pad (432; 532; 732; 832; 932), and the second bonding member (350; 950) is disposed to enclose the fourth opening (9350) of the fourth pad (435; 835; 935).

Paragraph 20. A printed circuit board (PCB) (300) comprising: a plurality of via structures (331) comprising a first via structure (331a) and a second via structure (331b) for electrically connecting a surface and an opposite surface of the PCB (300); and an interposer substrate (4301; 8301; 9301) comprising a first surface (4301a) and a second surface (4301b) that is opposite to the first surface (4301a), wherein the first via structure (331a) comprises: a first pad (432; 532; 732; 832; 932) formed on the first surface (4301a) of the interposer substrate (4301; 8301; 9301); a fourth pad (435; 835; 935) formed on the second surface (4301b) that is opposite to the first surface (4301a); a second pad (433; 533; 633; 733; 833; 933) formed in the interposer substrate (4301; 8301; 9301) closer to the first pad (432; 532; 732; 832; 932) than the fourth pad (435; 835; 935); a third pad (434; 634; 834; 934) formed in the interposer substrate (4301; 8301; 9301) closer to the fourth pad (435; 835; 935) than the first pad (432; 532; 732; 832; 932); a second via (437; 837; 937) connected to the second pad (433; 533; 633; 733; 833; 933) and the third pad (434; 634; 834; 934); a first via (436; 536; 636; 736; 836; 936) connected to the first pad (432; 532; 732; 832; 932) and the second pad (433; 533; 633; 733; 833; 933); and a plurality of third vias (438; 638; 838; 938) connected to the fourth pad (435; 835; 935) and the third pad (434; 634; 834; 934), and wherein the second pad (433; 533; 633; 733; 833; 933) comprises a first opening (4330; 5330; 6330; 7330; 9330) formed between the plurality of first vias (436; 536; 636; 736; 836; 936) and connected to an inside of the second via (437; 837; 937).

All of the examples, embodiments and features set out in this disclosure may be combined in any suitable manner unless described as incompatible or mutually exclusive. Furthermore, features of the various examples and embodiments may be omitted unless described as essential.

## Claims

1. An interposer (330; 430; 830; 930) for connecting printed circuit boards (PCBs), the interposer comprising:
an interposer substrate (4301; 8301; 9301) comprising a first surface (4301a) and a second surface (4301b) that is opposite to the first surface (4301a); and
at least one via structure (331; 331a; 331b; 431) disposed on the interposer substrate (4301; 8301; 9301),
wherein the at least one via structure (331; 331a; 331b; 431) comprises:
a first pad (432; 532; 732; 832; 932) disposed on the first surface (4301a);
a second pad (433; 533; 633; 733; 833; 933) spaced apart from the first pad (432; 532; 732; 832; 932) and disposed in the interposer substrate (4301; 8301; 9301);
a third pad (434; 634; 834; 934) spaced apart from the second pad (433; 533; 633; 733; 833; 933) in a direction of the second surface (4301b);
at least one first via (436; 536; 636; 736; 836; 936) that extends between the first pad (432; 532; 732; 832; 932) and the second pad (433; 533; 633; 733; 833; 933); and
a second via (437; 837; 937) that extends between the second pad (433; 533; 633; 733; 833; 933) and the third pad (434; 634; 834; 934),
wherein the second pad (433; 533; 633; 733; 933) comprises a first body (4331; 5331; 6331; 7331) and at least one first opening (4330; 5330; 6330; 7330; 9330) passing through the first body, and
wherein the at least one first via is connected to the first body (4331; 5331; 6331; 7331) of the second pad (433; 533; 633; 733; 833; 933).

2. The interposer (330; 430; 830; 930) of claim 1, wherein
the second via (437; 837; 937) comprises:
a core portion (4371) that extends between the second pad (433) and the third pad (434) in a height direction of the interposer substrate (4301); and
a boundary portion (4372; 6372; 7372) configured to enclose the core portion (4371) in the height direction,
and when the first surface (4301a) is viewed, the first opening (4330; 5330; 6330; 7330; 9330) of the second pad (433; 533; 633; 733; 833; 933) at least partially overlaps the core portion.

3. The interposer (330; 430; 830; 930) of claim 2, wherein, based on a cross-section perpendicular to the height direction,
a diameter (4372a) of the boundary portion (4372; 6372; 7372) is less than or equal to 220 micrometers (µm), and
a diameter (433a) of the second pad (433; 533; 633; 733; 833; 933) is at least 60 µm greater than the diameter (4372a) of the boundary portion (4372; 6372; 7372).

4. The interposer (330; 430; 830; 930) of claim 2 or 3, wherein the core portion (4371) and the interposer substrate (4301; 8301; 9301) have different coefficients of thermal expansion.

5. The interposer (330; 430; 830; 930) of claims 2 to 4, wherein
a dielectric (4371a) is positioned in the core portion (4371), and
the dielectric (4371a) is exposed to an outside of the second via (437;837;937) through the first opening (4330; 5330; 6330; 7330; 9330).

6. The interposer (330; 430; 830; 930) of one of claims 1 to 5, wherein the at least one first via (436;536;636;736;836;936) comprises
a plurality of first vias (436; 536; 636; 736; 836; 936), and wherein
each of the plurality of first vias (436; 536; 636; 736; 836; 936) is connected to the first body of the second pad.

7. The interposer (330; 430; 830; 930) of one of claims 1 to 6, wherein the first via 736 comprises an arc-shaped cross-section and encloses the first opening (7330) formed in the second pad (733).

8. The interposer (330; 430; 830; 930) of one of claims 1 to 7, wherein the second pad (633) further comprises:
a first extension opening (6332; 6332a) passing through the first body (6331) and extending from a circumference of the first opening (6330) and
wherein the second pad (633) is divided into at least two parts (633a; 633b; 633c) by the first extension opening (6332a).

9. The interposer (330; 430; 830; 930) of one of claims 1 to 8, wherein the via structure (331; 331a; 331b; 431) further comprises:
at least one first stacked via (839a) stacked between the first via (436; 536; 636; 736; 836; 936) and the second pad (433; 533; 633; 733; 833; 933) in a height direction of the interposer substrate (4301;8301;9301).

10. The interposer (330; 430; 830; 930) of one of claims 1 to 9, wherein an area of a third connecting region (4363) in which the first via (436; 536; 636; 736; 836; 936) is connected to the first pad (432; 532; 732; 832; 932) is greater than an area of a first connecting region (4361; 5361) in which the first via (436; 536; 636; 736; 836; 936) is connected to the second pad (433; 533; 633; 733; 833; 933).

11. The interposer (330; 430; 830; 930) of one of claims 1 to 10, wherein
the at least one via structure (331; 331a; 331b; 431) comprises a plurality of via structures (331; 331a; 331b; 431), and
a distance (D1) between central axes (X1; X2) of each of the plurality of via structures (331; 331a; 331b; 431) is less than or equal to 550 µm.

12. The interposer (330; 430; 830; 930) of one of claims 1 to 11, wherein
the third pad (434; 634; 834; 934) is disposed in the interposer substrate (4301; 8301; 9301), and
the at least one via structure (331; 331a; 331b; 431) further comprises:
a fourth pad (435; 835; 935) spaced apart from the third pad (434; 634; 834; 934) and disposed on the second surface (4301b); and
at least one third via (438; 638; 838; 938) that extends between the third pad (434; 634; 834; 934) and the fourth pad (435; 835; 935), and
the third pad (434; 634; 834; 934) comprises:
a second body (4341; 6341), wherein the at least one third via (438; 638; 838; 938) is connected to the second body (4341; 6341); and
at least one second opening (4340; 6340; 9340) passing through the second body (4341; 6341).

13. An electronic device (201) comprising:
a housing (210); and
a printed circuit board (PCB) (300) disposed in an inner space of the housing (210),
wherein the PCB (300) comprises:
a first circuit board (310);
a second circuit board (320); and
at least one interposer (330; 430; 830; 930) as set out in accordance with claim 12, disposed between the first circuit board (310) and the second circuit board (320) and configured to connect the first circuit board (310) to the second circuit board (320) in a stack.

14. The electronic device of claim 13, further comprising:
a first bonding member (340; 940) configured to connect the first circuit board (310) to the interposer (330; 430; 830; 930); and
a second bonding member (350; 950) configured to connect the second circuit board (320) to the interposer (330; 430; 830; 930).

15. The electronic device of claim 14, wherein
the first bonding member (340; 940) is in contact with the first pad (432; 532; 732; 832; 932),
the second bonding member (350; 950) is in contact with the fourth pad (435; 835; 935),
the first pad (432; 532; 732; 832; 932) comprises:
a third body (4321; 7321; 9321); and
a third opening (9320) passing through the third body (4321; 7321; 9321),
the fourth pad (435; 835; 935) comprises:
a fourth body (9351); and
a fourth opening (9350) passing through the fourth body (9351),
the first bonding member (340; 940) is disposed to enclose the third opening (9320) of the first pad (432; 532; 732; 832; 932), and
the second bonding member (350; 950) is disposed to enclose the fourth opening (9350) of the fourth pad (435; 835; 935).
